# EUROPÄISCHE PATENTSCHRIFT

(11) **EP 2 238 632 B1**
(45) Veröffentlichungstag und Bekanntmachung des Hinweises auf die Patenterteilung: **24.03.2021**
(21) Anmeldenummer: 09705293.0
(22) Anmeldetag: 29.01.2009
(51) Int. Cl.: H01L 51/52

(54) **VORRICHTUNG MIT VERKAPSELUNGSANORDNUNG**
DEVICE COMPRISING AN ENCAPSULATION UNIT
DISPOSITIF A SYSTEME D'ENCAPSULAGE

(30) Priorität: 30.01.2008 DE 102008006721; 21.04.2008 DE 102008019900; 02.07.2008 DE 102008031405; 23.09.2008 DE 102008048472
(43) Veröffentlichungstag der Anmeldung: 13.10.2010
(73) Patentinhaber: OSRAM OLED GmbH, 93055 Regensburg (DE)
(72) Erfinder: SCHMID, Christian, 93049 Regensburg (DE); SCHLENKER, Tilman, 93152 Nittendorf (DE); ZULL, Heribert, 93049 Regensburg (DE); PÄTZOLD, Ralph, 91154 Roth (DE); KLEIN, Markus, 93105 Tegernheim (DE); HEUSER, Karsten, 91056 Erlangen (DE)
(74) Vertreter: Epping - Hermann - Fischer
(86) Internationale Anmeldenummer: PCT/DE2009/000134
(87) Internationale Veröffentlichungsnummer: WO 2009/095006

(56) Entgegenhaltungen:
- US-A1- 2001 031 379
- US-A1- 2005 248 270
- US-A1- 2007 295 390
- SANG-HEE KO PARK, JIYOUNG OH, CHI-SUN HWANG, JEONG-IK LEE, YONG SUK YANG, HYE YONG CHU: "Ultrathin Film Encapsulation of an OLED by ALD" ELECTROCHEMICAL AND SOLID-STATE LETTERS, Bd. 8, Nr. 2, 6. Januar 2005 (2005-01-06), Seiten H21-H23, XP002530094
- LIFKA H ET AL: "THIN FILM ENCAPSULATION OF OLED DISPLAYS WITH A NONON STACK" 2004 SID INTERNATIONAL SYMPOSIUM DIGEST OF TECHNICAL PAPERS. SEATTLE, WA, MAY 25 - 27, 2004; [SID INTERNATIONAL SYMPOSIUM DIGEST OF TECHNICAL PAPERS], SAN JOSE, CA : SID, US, Bd. 35, Nr. 2, 26. Mai 2004 (2004-05-26), Seiten 1384-1387, XP001222870
- LANGEREIS E ET AL: "Plasma-assisted atomic layer deposition of Al2O3 moisture permeation barriers on polymers" APPLIED PHYSICS LETTERS, AIP, AMERICAN INSTITUTE OF PHYSICS, MELVILLE, NY, US, Bd. 89, Nr. 8, 25. August 2006 (2006-08-25), Seiten 81915-081915, XP012088600 ISSN: 0003-6951
- YUN SUN ET AL: "Passivation of organic light-emitting diodes with aluminum oxide thin films grown by plasma-enhanced atomic layer deposition" APPLIED PHYSICS LETTERS, AIP, AMERICAN INSTITUTE OF PHYSICS, MELVILLE, NY, US, Bd. 85, Nr. 21, 1. Januar 2004 (2004-01-01), Seiten 4896-4898, XP012063494 ISSN: 0003-6951

## Beschreibung

Es wird eine Vorrichtung mit einer Verkapselungsanordnung angegeben.

Diese Patentanmeldung beansprucht die Prioritäten der deutschen Patentanmeldung 10 2008 006 721.0, der deutschen Patentanmeldung 10 2008 019 900.1, der deutschen Patentanmeldung 10 2008 031 405.6 und der deutschen Patentanmeldung 10 2008 048 472. 5.

Feuchtigkeitsempfindliche Displays mit organischen Leuchtdioden (OLEDs) werden heutzutage mittels aufwändigen Deckglasvorrichtungen verkapselt, die die aktiven Bereiche des OLED-Displays in einem Hohlraum umschließen. Das Deckglas wird hierbei üblicherweise auf einem Substrat mittels einer um die aktiven Bereiche des OLED-Displays umlaufenden Klebstoffschicht aufgeklebt, die jedoch oft aufgrund des verwendeten Materials und/oder aufgrund mechanischer Beanspruchung nicht dauerhaft dicht gegenüber Feuchtigkeit und/oder Sauerstoff ist. Daher ist es erforderlich, bei derartigen bekannten OLED-Displays zusätzlich in den Hohlraum zwischen Substrat und Deckglas Gettermaterialien einzubringen, die Feuchtigkeit und/oder Sauerstoff binden können.

Derartige Verkapselungslösungen stellen jedoch hohe Anforderungen an die verwendeten Materialien und sind üblicherweise zeit- und kostenintensiv in der Herstellung.

Die Druckschrift US 2001/0031379 A1 offenbart ein organisches elektrolumineszierendes Bauelement mit einem Substrat, auf dem eine Anode, eine Lochtransportschicht, eine organische elektrolumineszierende Schicht und eine Kathode aufgebracht sind. Darüber ist eine Schutzschicht, etwa Aluminiumoxid, mittels eines plasmalosen ALD-Verfahrens aufgebracht. Über der Schutzschicht kann eine Harzschicht aus Parylene oder einem anderen Kunststoff mittels Dampfabscheidung, Spin-Coating oder Aufdrucken aufgebracht werden. Alternativ kann zur Bildung der Schutzschicht zusätzlich zu einer ALD-Schicht auch noch darüber oder darunter eine weitere Schicht, etwa aus Siliziumnitrid, aufgebracht werden.

Die Druckschrift Sang-Hee Ko Park et al.: "Ultrathin Film Encapsulation of an OLED by ALD", Electro-chemical and Solid-State Letters 8, H21-H23, 2005 beschreibt Experimente mit einem PES-Substrat sowie einer OLED auf einem Glassubstrat, auf denen jeweils Verkapselungen aufgebracht wurden. Als Verkapselungen werden Schichtkombinationen beschrieben, die beispielsweise aus einem oder zwei Paaren aus einer mittels PECVD hergestellten SiNₓ-Schicht und einer darüber aufgebrachten amorphen mittels ALD hergestellten AlOₓ-Schicht oder alternativ dazu aus einer Parylene-Schicht und darauf einer ALD-AlOₓ-Schicht bestehen.

Die Druckschrift H. Lifka et al.: "Thin Film Encapsulation of OLED Displays with a NONON Stack", SID 04 DIGEST Bd. 35, No. 2, 1384 - 1387, 2004 beschreibt eine Verkapselung von OLEDs, die aus einer abwechselnden Abfolge von PECVD-hergestellten Siliziumoxid- und Siliziumnitridschichten besteht.

Die Druckschrift US 2005/0248270 A1 beschreibt eine verkapselte OLED mit einer Barriereschicht, beispielsweise aus Tantalnitrid, und darüber einer anorganischen Schutzschicht, die beispielsweise mittels PECVD oder ALD aufgebracht wird. Darüber sind eine Polymerschicht und ein Deckel aus Glas aufgebracht.

Die Druckschrift US 2007/0295390 A1 beschreibt eine Solarzelle, die eine Verkapselungsschicht, eine Polymerschicht und darüber eine Glasschicht aufweist.

Eine Aufgabe zumindest einer Ausführungsform ist es, eine Vorrichtung mit einem Bauelement und einer Verkapselungsanordnung zur Verkapselung des Bauelements gegenüber Feuchtigkeit und/oder Sauerstoff anzugeben.

Diese Aufgabe wird durch Gegenstände mit den Merkmalen der unabhängigen Patentansprüche gelöst. Vorteilhafte Ausführungsformen und Weiterbildungen der Gegenstände sind in den abhängigen Ansprüchen gekennzeichnet und gehen weiterhin aus der nachfolgenden Beschreibung und den Zeichnungen hervor.

Eine Vorrichtung gemäß zumindest einer Ausführungsform umfasst insbesondere ein Bauelement und eine Verkapselungsanordnung. Die Verkapselungsanordnung ist dabei geeignet, das Bauelement gegenüber Feuchtigkeit und/oder Sauerstoff zu verkapseln.

"Verkapseln" und "Verkapselung" bezeichnet hier und im Folgenden die Eigenschaft der Verkapselungsanordnung, eine Barriere gegenüber Feuchtigkeit und/oder Sauerstoff zu bilden, so dass die Verkapselungsanordnung nicht von diesen Stoffen durchdrungen werden kann. Beispielsweise kann die Verkapselungsanordnung zwischen dem Bauelement und einer Umgebungsatmosphäre mit Feuchtigkeit und/oder Sauerstoff angeordnet sein, so dass das Bauelement vor der Umgebungsatmosphäre geschützt ist. Dabei kann alleine die Verkapselungsanordnung ausreichend sein, das Bauelement zu verkapseln, beispielsweise dadurch dass die Verkapselungsanordnung das Bauelement vollständig umgibt. Weiterhin kann "verkapseln" beziehungsweise "Verkapselung" durch die Verkapselungsanordnung auch bedeuten, dass die Verkapselungsanordnung zusammen mit weiteren im Folgenden genannten Elementen wie etwa einem Substrat oder einer Abdeckung das Bauelement verkapselt.

"Verkapseln" und "Verkapselung" kann hier und im Folgenden vor allem eine hermetisch dichte Abdichtung und Barriere gegenüber Feuchtigkeit und/oder Sauerstoff bezeichnen. Das kann bedeuten, dass Feuchtigkeit und/oder Sauerstoff die Verkapselungsanordnung nicht durchdringen kann. Insbesondere kann die hermetisch dichte Verkapselungsanordnung das Bauelement vor Feuchtigkeit und/oder Sauerstoff derart schützen, dass dieses nicht durch Feuchtigkeit und/oder Sauerstoff aus der Umgebungsatmosphäre in seiner Funktionsfähigkeit und/oder Zusammensetzung beeinträchtigt und geschädigt wird.

Beispielsweise kann das Bauelement zumindest ein Element oder einen Teilbereich aufweisen, das beziehungsweise der empfindlich gegenüber Feuchtigkeit und/oder Sauerstoff ist. Das Element beziehungsweise der Teilbereich kann beispielsweise durch Feuchtigkeit und/oder Sauerstoff in seiner Funktionsfähigkeit und/oder Zusammensetzung beeinträchtigbar sein. Durch die Verkapselungsanordnung kann erreicht werden, dass das feuchtigkeits- und/oder sauerstoffempfindliche Element beziehungsweise der feuchtigkeits- und/oder sauerstoffempfindliche Teilbereich geschützt ist.

Weiterhin kann das Bauelement zumindest ein Element oder einen Teilbereich aufweisen, das beziehungsweise der durchlässig für Feuchtigkeit und/oder Sauerstoff ist, so dass Feuchtigkeit und/oder Sauerstoff in das Element beziehungsweise den Teilbereich eindringen kann und/oder dieses beziehungsweise diesen durchdringen kann. Dies kann beispielsweise durch Absorption und/oder Diffusion von Feuchtigkeit und/oder Sauerstoff durch das Element beziehungsweise den Teilbereich möglich sein. Durch die Verkapselungsanordnung kann in diesem Fall erreicht werden, dass Feuchtigkeit und/oder Sauerstoff in das durchlässige Element beziehungsweise den Teilbereich nicht eindringen und/oder dieses beziehungsweise diesen nicht durchdringen kann.

Die Verkapselungsanordnung kann bevorzugt zumindest eine erste Schicht auf zumindest einer Oberfläche des Bauelements und darüber zumindest eine zweite Schicht aufweisen. Die erste Schicht ist zwischen der Oberfläche des Bauelements und der zweiten Schicht angeordnet sein.

Hier und im Folgenden bezeichnen "über", "oben" und "darüber" Anordnungen von Elementen in einer Richtung vom Bauelement aus gesehen. Das kann insbesondere bedeuten, dass ein zweites Element, das über einem ersten Element angeordnet ist beziehungsweise das vom ersten Element aus oben angeordnet ist, auf einer dem Bauelement abgewandten Seite des ersten Elements angeordnet ist.

Dass eine Schicht oder ein Element "auf" einer anderen Schicht oder einem anderen Element angeordnet oder aufgebracht ist, kann dabei hier und im Folgenden bedeuten, dass die eine Schicht oder das eine Element unmittelbar in direktem mechanischen und/oder elektrischen Kontakt auf der anderen Schicht oder dem anderen Element angeordnet ist. Weiterhin kann es auch bedeuten, dass die eine Schicht oder das eine Element mittelbar auf der anderen Schicht oder dem anderen Element angeordnet ist. Dabei können dann weitere Schichten und/oder Elemente zwischen der einen und der anderen Schicht beziehungsweise zwischen dem einen und dem anderen Element angeordnet sein.

Dass eine Schicht oder ein Element "zwischen" zwei anderen Schichten oder Elementen angeordnet ist, kann hier und im Folgenden bedeuten, dass die eine Schicht oder das eine Element unmittelbar in direktem mechanischen und/oder elektrischen Kontakt oder in mittelbarem Kontakt zur einen der zwei anderen Schichten oder Elementen und in direktem mechanischen und/oder elektrischen Kontakt oder in mittelbarem Kontakt zur anderen der zwei anderen Schichten oder Elementen angeordnet ist. Dabei können bei mittelbarem Kontakt dann weitere Schichten und/oder Elemente zwischen der einen und zumindest einer der zwei anderen Schichten beziehungsweise zwischen dem einen und zumindest einem der zwei anderen Element angeordnet sein.

Die hier beschriebene Verkapselungsanordnung mit zumindest der ersten und der zweiten Schicht kann eine wirksame und effektive Verkapselung durch die im Folgenden beschriebenen Ausführungsformen und Ausführungsbeispiele ermöglichen. Die effektive Verkapselung kann gerade durch die Kombination und das Zusammenwirken der zumindest einen ersten und einen zweiten Schicht bewirkt werden.

Die erste Schicht und die zweite Schicht können jeweils Materialien aufweisen, die geeignet sind, durch die Kombination der ersten mit der zweiten Schicht das Bauelement vor schädigenden Einflüssen der Umgebung zu schützen, also etwa vor Sauerstoff und/oder Feuchtigkeit. Die erste Schicht und die zweite Schicht können insbesondere jeweils ein anorganisches Material aufweisen oder jeweils aus einem solchen sein.

Die erste Schicht kann ein Oxid, ein Nitrid oder ein Oxinitrid aufweisen oder aus einem solchen sein. Beispielsweise kann das Oxid, Nitrid oder Oxinitrid Aluminium, Silizium, Zinn, Zink, Titan, Zirkonium, Tantal, Niobium oder Hafnium umfassen. Besonders bevorzugt kann die erste Schicht Siliziumnitrid (SiₓN_{y}), wie etwa Si₂N₃, Siliziumoxid (SiOₓ) , wie etwa SiO₂, Aluminiumoxid, etwa Al₂O₃, und/oder Titanoxid, etwa TiO₂, aufweisen. Weiterhin kann die erste Schicht auch ein transparentes leitfähiges Oxid (TCO) aufweisen, wie weiter unten beschrieben ist. Alternativ oder zusätzlich kann die erste Schicht ein Metall oder eine Legierung aufweisen oder aus einem solchen sein. Die erste Schicht kann dabei beispielsweise Aluminium oder eine Aluminiumlegierung aufweisen. Alternativ oder zusätzlich kann die erste Schicht auch eines der vorab in Zusammenhang mit den Oxiden, Nitriden und Oxinitriden genannten Metalle aufweisen.

Die erste Schicht kann eine Volumenstruktur in Form einer keramischen Schicht und/oder in Form einer kristallinen, polykristallinen, amorphen und/oder glasartigen Struktur aufweisen.

Die vorab genannten Materialien können zur Herstellung der ersten Schicht beispielsweise mittels plasmaunterstützter chemischer Dampfphasenabscheidung ("plasma-enhanced chemical vapor deposition", PECVD) aufgebracht werden. Dabei kann in einem Volumen über und/oder um das Bauelement herum ein Plasma erzeugt werden, wobei dem Volumen zumindest zwei gasförmigen Ausgangsverbindungen zugeführt werden, die in dem Plasma ionisiert und zur Reaktion miteinander angeregt werden können. Durch die Erzeugung des Plasmas kann es möglich sein, dass die Temperatur, auf die die zumindest eine Oberfläche des Bauelements aufgeheizt werden muss, um eine Erzeugung der ersten Schicht zu ermöglichen, im Vergleich zu einem plasmalosen CVD-Verfahren erniedrigt werden kann. Das kann insbesondere vorteilhaft sein, wenn das Bauelement bei einer Temperatur oberhalb einer Maximaltemperatur irreversibel geschädigt werden würde. Die Maximaltemperatur kann bei den insbesondere weiter unten beschriebenen Bauelementen und dabei besonders bei den organischen elektronischen Bauelementen beispielsweise etwa 120°C betragen, so dass die Temperatur, bei der die erste Schicht aufgebracht wird, kleiner als 120°C und bevorzugt kleiner oder gleich 80°C sein kann.

Alternativ dazu kann die erste Schicht mittels einer physikalischen Gasphasenabscheidung wie etwa Sputtern, ionenunterstützten Abscheideverfahren oder thermischem Verdampfen aufgebracht werden.

Weiterhin kann die erste Schicht auch ein Glas aufweisen oder aus einem solchen sein. Das Glas kann dabei beispielsweise eines oder mehrere der oben genannten Oxide aufweisen. Das Glas kann mittels Plasmaspritzen aufbringbar sein beziehungsweise aufgebracht werden.

Beim Plasmaspritzen kann in einem so genannten Plasmabrenner zwischen zumindest einer Anode und zumindest einer Kathode durch Hochspannung ein Lichtbogen erzeugt werden, durch den ein Gas oder Gasgemisch geleitet und dadurch ionisiert werden kann. Das Gas oder Gasgemisch kann beispielsweise Argon, Stickstoff, Wasserstoff und/oder Helium aufweisen. In die durch den Lichtbogen und die Gas- beziehungsweise Gasgemischströmung erzeugte Plasmaströmung kann beispielsweise pulverförmiges Material für die erste Schicht eingesprüht werden. Das pulverförmige Material kann durch die Temperatur des Plasmas aufgeschmolzen und mittels der Plasmaströmung auf die zumindest eine Oberfläche des Bauelements aufgebracht wird. Das pulverförmige Material kann beispielsweise mit einer mittleren Korngröße von kleiner oder gleich einigen hundert Mikrometer, bevorzugt kleiner oder gleich 100 Mikrometer, und ferner größer oder gleich 100 Nanometer, bevorzugt größer oder gleich 1 Mikrometer, bereitgestellt werden. Je feiner das Material bereitgestellt wird, also je geringer die mittlere Korngröße ist, desto gleichmäßiger kann die erste Schicht aufgebracht werden. Je gröber das Material bereitgestellt wird, also je größer die mittlere Korngröße ist, desto rascher kann die erste Schicht aufgebracht werden. Weiterhin können die Struktur und auch die Qualität der ersten Schicht von der Geschwindigkeit, der Temperatur und/oder der Zusammensetzung des Plasmagases abhängen.

Alternativ zum Plasmaspritzen kann eine ein Glas aufweisende erste Schicht auch mittels Flammspritzen oder mittels eines thermischen Verdampfungsverfahrens aufgebracht werden.

Die erste Schicht kann weiterhin auch eine Schichtenfolge aus zumindest zwei Schichten mit unterschiedlichen Materialien aufweisen. Das kann bedeuten, dass als erste Schicht die Schichtenfolge mit zumindest zwei unterschiedlichen Schichten aufgebracht ist. Beispielsweise kann die Schichtenfolge eine Schicht mit einem Oxid und eine Schicht mit einem Nitrid aufweisen. Die Schichtenfolge kann auch eine Mehrzahl von ersten Schichten mit einem ersten Material, etwa einem Nitrid, und/oder eine Mehrzahl von zweiten Schichten mit einem zweiten Material, etwa einem Oxid, aufweisen, die abwechselnd aufeinander aufgebracht sind. Bezeichnet man eine nitridhaltige Schicht mit "N" und eine oxidhaltige Schicht mit "O", so kann die erste Schicht eine Schichtenfolge aufweisen, die beispielsweise in einer Abfolge NON oder NONON oder auch ONO oder ONONO ausgebildet ist. Die Schichten der Schichtenfolge der ersten Schicht können jeweils Dicken von größer oder gleich 50 Nanometer und bevorzugt größer oder gleich 100 Nanometer aufweisen. Durch die Mehrzahl von Schichten einer als Schichtenstapel ausgebildeten ersten Schicht kann es möglich sein, dass die Ausdehnung von Gitterfehlern wie etwa Poren oder Versetzungen innerhalb der ersten Schicht verringert wird und dass sich Gitterfehler einer Schicht des Schichtenstapels auf diese Schicht beschränkt sind und sich nicht durch die gesamte erste Schicht erstrecken.

Durch die genannten Verfahren zum Aufbringen der ersten Schicht kann diese kostengünstig mit einer hohen Wachstumsrate aufgebracht werden. Insbesondere kann die erste Schicht nach dem Aufbringen eine Dicke von größer oder gleich 50 Nanometer und besonders bevorzugt eine Dicke von größer oder gleich 100 Nanometer aufweisen. Weiterhin kann die erste Schicht eine Dicke von kleiner oder gleich 2 Mikrometer und bevorzugt von kleiner oder gleich 1 Mikrometer aufweisen.
Durch eine derart dicke erste Schicht kann die Verkapselungsanordnung neben der Verkapselung auch einen mechanischen Schutz für das Bauelement gegenüber schädigenden äußeren Einflüssen ermöglichen.

Durch die genannten Verfahren, insbesondere bei Temperaturen des Bauelements von kleiner als 120°C und besonders bevorzugt von kleiner als 80°C, kann die erste Schicht direkt auf dem Bauelement aufbringbar sein, ohne dass das Bauelement oder Teile davon beschädigt würden.

Die Volumenstruktur der ersten Schicht liegt in kristalliner und/oder polykristalliner Form vor. Dabei kann es möglich sein, dass die Volumenstruktur der ersten Schicht beispielsweise Struktur- und/oder Gitterfehler wie etwa Versetzungen, Korngrenzen und/oder Stapelfehler aufweist. Die Volumenstruktur der ersten Schicht kann dabei durch die oben beschriebenen Aufbringverfahren bedingt sein und/oder durch die Oberflächenstruktur der Oberfläche, auf der die erste Schicht aufgebracht wird. Beispielsweise kann das Bauelement auf der zumindest einen Oberfläche, auf der die Verkapselungsanordnung angeordnet ist, Verunreinigungen in Form von Schmutz, Staub oder sonstigen Partikeln, die beispielsweise durch die Herstellungsprozesse des Bauelements selbst bedingt sind, aufweisen. Derartige Partikel können die Oberfläche des Bauelements teilweise abdecken und/oder abschatten, so dass die erste Schicht nicht gleichmäßig und flächendeckend auf der Oberfläche des Bauelements aufgebracht werden kann. Dadurch kann die Bildung von unerwünschten Poren oder Löchern in der ersten Schicht begünstigt werden.

Insbesondere sowohl die vorab genannten Struktur- und Gitterfehler der Volumenstruktur der ersten Schicht als auch Poren in der Oberflächenstruktur der ersten Schicht können unerwünschte Permeationspfade für Feuchtigkeit und/oder Sauerstoff bilden, die eine Diffusion durch die erste Schicht ermöglichen oder zumindest erleichtern können.

Weiterhin kann die erste Schicht auf der dem Bauelement abgewandten Oberfläche, auf der die zweite Schicht angeordnet ist, eine Oberflächenstruktur in Form von makroskopischen topographischen Strukturen wie etwa Steigungen, Erhebungen, Winkel, Kanten, Ecken Vertiefungen, Gräben, Furchen, Mikrolinsen und/oder Prismen und/oder in Form von mikroskopischen topographischen Strukturen wie etwa einer Oberflächenrauhigkeit und/oder Poren aufweisen. Hierbei werden Strukturen der Oberflächenstruktur, die mittels sichtbaren Lichts auflösbar sind, den makroskopischen Strukturen zugerechnet, während mikroskopische Strukturen gerade nicht mehr mittels sichtbaren Lichts auflösbar sind. Das kann bedeuten, dass hier als makroskopisch bezeichnete Strukturen Abmessungen von größer oder gleich etwa 400 Nanometer aufweisen, während mikroskopische Strukturen Abmessungen aufweisen, die kleiner als etwa 400 Nanometer sind.

Die Oberflächenstruktur kann durch die genannten Aufbringverfahren selbst bedingt sein oder auch, insbesondere im Falle von makroskopischen Strukturen, durch geeignete weitere Verfahrensschritte wie etwa das Abscheiden durch eine Maske und/oder nachträgliches Bearbeiten mittels mechanischen und/oder chemischen abtragenden Verfahren herstellbar sein. Makroskopische Strukturen können beispielsweise bei einer transparenten Verkapselungsanordnung zur Lichtbrechung und/oder -streuung geeignet sein, insbesondere bei einer Vorrichtung mit einem weiter unten beschriebenen als OLED ausgeführten Bauelement, bei dem Licht durch die Verkapselungsanordnung abgestrahlt werden kann.

Die zweite Schicht kann geeignet sein, in Kombination mit der ersten Schicht die hermetisch dichte Verkapselungsanordnung zu ermöglichen. Dazu kann die zweite Schicht insbesondere geeignet sein, die vorab genannten Permeationspfade, die in der ersten Schicht vorkommen können, abzudichten

Die zweite Schicht ist dazu direkt auf der ersten Schicht und in unmittelbarem Kontakt mit der ersten Schicht angeordnet. Das kann bedeuten, dass die zweite Schicht mit der ersten Schicht eine gemeinsame Grenzfläche aufweist und weiterhin eine von der gemeinsamen Grenzfläche abgewandte obere Oberfläche. Die zweite Schicht kann derart ausgebildet sein, dass sie der Oberflächenstruktur der ersten Schicht zumindest teilweise oder annähernd folgen kann, was bedeuten kann, dass insbesondere auch die obere Oberfläche der zweiten Schicht der topographischen Struktur der Grenzfläche zumindest teilweise oder annähernd folgt.

Dass die obere Oberfläche der zweiten Schicht der Grenzfläche zwischen der ersten und zweiten Schicht und damit der Oberflächenstruktur der zweiten Schicht zumindest teilweise folgt, kann hier und im Folgenden bedeuten, dass die obere Oberfläche der zweiten Schicht ebenfalls eine topographische Oberflächenstruktur aufweist. Die topographische Oberflächenstruktur der oberen Oberfläche der zweiten Schicht kann dabei bevorzugt gleich oder ähnlich der topographischen Oberflächenstruktur der dem Bauelement abgewandten Oberfläche der ersten Schicht ausgebildet sein. "Gleich" oder "ähnlich" kann im Zusammenhang mit zwei oder mehreren topographischen Oberflächenstrukturen insbesondere bedeuten, dass die zwei oder mehreren topographischen Oberflächenstrukturen gleiche oder ähnliche Höhenprofile mit einander entsprechenden Strukturen wie etwa Erhebungen und Vertiefungen aufweisen. Beispielsweise können die zwei oder mehreren topographischen Oberflächenstrukturen in diesem Sinne jeweils lateral nebeneinander angeordnete Erhebungen und Vertiefungen in einer bestimmten charakteristischen Abfolge aufweisen, die beispielsweise abgesehen von relativen Höhenunterschieden der Erhebungen und Vertiefungen für die zwei oder mehreren topographischen Oberflächenstrukturen gleich sind.

Mit anderen Worten kann eine Oberfläche, die der topographischen Oberflächenstruktur einer andere Fläche zumindest teilweise folgt, eine Erhebung angeordnet über einer Erhebung der topographischen Oberflächenstruktur der anderen Fläche beziehungsweise eine Vertiefung angeordnet über einer Vertiefung der topographischen Oberflächenstruktur der anderen Fläche aufweisen. Der relative Höhenunterschied zwischen benachbarten Erhebungen und Vertiefungen der einen Oberfläche kann dabei auch unterschiedlich zum relativen Höhenunterschied der entsprechenden Erhebungen und Vertiefungen der topographischen Oberflächenstruktur der anderen Fläche sein.

Mit anderen Worten kann das bedeuten, dass die obere Oberfläche der zweiten Schicht und die Grenzfläche zwischen der ersten und zweiten Schicht parallel oder zumindest annähernd parallel verlaufen. Damit kann die zweite Schicht eine Dicke aufweisen, die unabhängig oder annähernd unabhängig von der Oberflächenstruktur der dem Bauelement abgewandten Oberfläche der ersten Schicht ist. "Annähernd parallel", "annähernd unabhängig" und "annähernd gleich bleibend" kann im Hinblick auf die Dicke der zweiten Schicht bedeuten, dass diese eine Dickenvariation kleiner oder gleich 10% und besonders bevorzugt von kleiner oder gleich 5% gemessen an der Gesamtdicke der zweiten Schicht aufweist. Eine derartige Ausbildung der zweiten Schicht mit einer derartigen geringen Dickenvariation kann auch als so genanntes "conformal coating" bezeichnet werden.

Weiterhin kann die zweite Schicht eine Dicke aufweisen, die kleiner als die Abmessungen von zumindest einigen Strukturen und insbesondere den oben genannten makroskopischen Strukturen der Oberflächenstruktur der ersten Schicht ist. Insbesondere kann die zweite Schicht auch denjenigen mikroskopischen Strukturen der Oberflächenstruktur der ersten Schicht folgen, deren Abmessungen größer als die Dicke der zweiten Schicht sind.

Die Dicke der zweiten Schicht kann weiterhin unabhängig von einer Volumenstruktur der ersten Schicht sein. Das kann bedeuten, dass die erste Schicht keine Dickenvariation von größer als 10% und besonders bevorzugt keine Dickenvariation von größer als 5% auch über den Teilbereichen der ersten Schicht aufweist, in der sich oben genannte Gitter- und/oder Strukturfehler der Volumenstruktur der ersten Schicht befinden und die sich insbesondere bis zur gemeinsamen Grenzfläche mit der zweiten Schicht erstrecken.

Weiterhin kann die Dicke der zweiten Schicht insbesondere auch unabhängig von Öffnungen, Erhebungen, Vertiefungen und Poren in der der zweiten Schicht zugewandten Oberfläche der ersten Schicht sein. Im Falle, dass derartige Oberflächenstrukturen hinsichtlich ihrer Abmessungen größer als die Dicke der zweiten Schicht sind, können diese durch die zweite Schicht mit gleichmäßiger und im obigen Sinne zumindest nahezu gleicher Dicke bedeckt sein, indem die zweite Schicht der Oberflächenstruktur folgt. Im Falle, dass die Oberflächenstrukturen hinsichtlich ihrer Abmessungen kleiner oder gleich der Dicke der zweiten Schicht sind, kann die zweite Schicht die Oberflächenstrukturen abdecken, ohne diesen zu folgen, und dabei aber ebenfalls eine im obigen Sinne zumindest nahezu gleich bleibende Dicke aufweisen. Insbesondere kann die zweite Schicht Öffnungen und/oder Poren in der ersten Schicht abdichten, die ein Tiefe-zu-Durchmesser-Verhältnis von größer oder gleich 10 und besonders bevorzugt von größer oder gleich 30 haben. Die Verkapselungsanordnung kann die hier beschriebene zumindest annährend gleiche Dicke der zweiten Schicht insbesondere auch dann aufweisen, wenn die erste Schicht eine Oberflächenstruktur mit überhängenden Strukturen, insbesondere überhängenden makroskopischen Strukturen, mit negativen Winkeln aufweisen.

Weiterhin kann die zweite Schicht eine Volumenstruktur aufweisen, die unabhängig von der Oberflächenstruktur der der zweiten Schicht zugewandten Oberfläche der ersten Schicht ist. Die zweite Schicht weist eine Volumenstruktur auf, die unabhängig von der Volumenstruktur der ersten Schicht ist. Das kann bedeuten, dass oberflächen- und/oder volumenspezifische Eigenschaften und Merkmale der ersten Schicht wie etwa die oben erwähnten Oberflächenstrukturen und/oder Gitter- und/oder Strukturfehler in der Volumenstruktur der ersten Schicht keinen Einfluss auf die Volumenstruktur der zweiten Schicht haben.

Die zweite Schicht kann ein Oxid, ein Nitrid und/oder ein Oxinitrid wie im Zusammenhang mit der ersten Schicht beschrieben aufweisen. Besonders bevorzugt kann die zweite Schicht Aluminiumoxid, etwa Al₂O₃, und/oder Tantaloxid, etwa Ta₂O₅, aufweisen.

Insbesondere weist die zweite Schicht eine Volumenstruktur auf, die eine höhere Amorphizität, also Unregelmäßigkeit im Sinne von Nah- und/oder Fernordnung der enthaltenen Materialien, als die erste Schicht aufweist. Das kann insbesondere bedeuten, dass die zweite Schicht eine derart hohe Amorphizität aufweist, dass keine Kristallinität beziehungsweise Kristallstruktur feststellbar ist. Gemäß Erfindung ist die zweite Schicht amorph, so dass die die zweite Schicht bildenden Materialien keine messbare Nah- und/oder Fernordnung aufweisen sondern eine rein statistische, unregelmäßige Verteilung aufweisen.

Als Referenz zur Feststellung der Amorphizität der zweiten Schicht und auch der ersten Schicht kann dabei beispielsweise eine dem Fachmann bekannte Flachwinkelmessung in einem Röntgendiffraktometer dienen, bei der für eine amorphe Schicht keine Kristallinität in Form einer kristallinen, teilkristallinen und/oder polykristallinen Struktur feststellbar ist.

Beispielsweise wurde eine Verkapselungsanordnung mit einer zweiten Schicht aus Al₂O₃ und einer Dicke von 10 Nanometern auf einer ersten Schicht mit zwei SiNₓ-Schichten mit jeweils einer Dicke von 200 Nanometern und zwischen diesen einer SiO₂-Schicht mit einer Dicke von 100 Nanometern mittels Röntgenbeugung unter streifendem Einfall (GIXRD) gemessen. Dabei konnte mittels des GIXRD-Verfahrens kein kristallines Material in der zweiten Schicht nachgewiesen werden.

Obwohl Schichten mit kristalliner, also nicht amorpher, Volumenstruktur oft eine höhere Dichte als Schichten mit amorpher Volumenstruktur aufweisen, wurde in Verbindung mit der hier beschriebenen Vorrichtung mit der Verkapselungsanordnung überraschend festgestellt, dass die zweite Schicht, wenn sie eine hohe Amorphizität aufweist, dennoch in Kombination mit der ersten Schicht eine hermetisch dichte Verkapselungsanordnung ermöglicht. Insbesondere kann es dabei von Vorteil sein, dass die amorphe zweite Schicht keine Struktur- und/oder Gitterfehler der ersten Schicht fortsetzt, so dass sich dadurch auch keine durchgehenden Permeationspfade für Feuchtigkeit und/oder Sauerstoff durch die Verkapselungsanordnung ausbilden können. Gerade durch die Kombination der ersten Schicht mit der amorphen zweiten Schicht kann eine Verkapselungsanordnung erreicht werden, die eine hermetische Dichtigkeit gegenüber Feuchtigkeit und/oder Sauerstoff und gleichzeitig eine ausreichend große Gesamtdicke aufweist, um auch einen mechanischen Schutz des Bauelements zu gewährleisten.

Die zweite Schicht kann durch ein Verfahren auf der ersten Schicht herstellbar sein, bei dem die Oberflächenstruktur und/oder die Volumenstruktur der ersten Schicht keinen Einfluss auf die Volumenstruktur der aufzubringenden zweiten Schicht haben. Die zweite Schicht kann insbesondere mittels eines Verfahrens herstellbar sein, dass das oder die für die zweite Schicht aufzubringenden Materialien ohne Fernordnung, also in einer unregelmäßigen Verteilung zur Herstellung einer amorphen Volumenstruktur aufbringbar sind. Die zweite Schicht kann dabei beispielsweise in Form von Einzelschichten des oder der aufzubringenden Materialien, so genannten Monolagen, aufgebracht werden, wobei jede der Monolagen der Oberflächenstruktur der zu beschichtenden Fläche folgt. Dabei können die Bestandteile und Materialien einer Monolage statistisch verteilt und unabhängig voneinander auf der gesamten zu beschichtenden Fläche verteilt und aufgebracht werden, wobei besonders bevorzugt die gesamte Fläche durchgehend mit der Monolage bedeckt ist. Die zu beschichtende Fläche kann hierbei die vom Bauelement abgewandte Oberfläche der ersten Schicht oder eine bereits auf der ersten Schicht aufgebrachte Monolage sein.

Ein Verfahren, mit dem es möglich sein kann, derartige Einzelschichten aufzubringen, kann als Variante einer Atomschichtenabscheidung bezeichnet werden. Eine Atomschichtenabscheidung ("atomic layer deposition", ALD) kann ein Verfahren bezeichnen, bei dem im Vergleich zu einem oben beschriebenen CVD-Verfahren zur Herstellung einer Schicht auf einer Oberfläche zuerst eine erste von zumindest zwei gasförmigen Ausgangverbindungen einem Volumen zugeführt wird, im dem das Bauelement bereitgestellt wird. Die erste Ausgangsverbindung kann auf der Oberfläche adsorbieren. Für die hier beschriebene Verkapselungsanordnung kann es vorteilhaft sein, wenn die erste Ausgangsverbindung unregelmäßig und ohne eine Fernordnung auf der Oberfläche adsorbiert. Nach einer bevorzugt vollständigen oder nahezu vollständigen Bedeckung der Oberfläche mit der ersten Ausgangsverbindung kann eine zweite der zumindest zwei Ausgangsverbindung kann zugeführt werden. Die zweite Ausgangsverbindung kann mit der an der Oberfläche möglichst unregelmäßig aber bevorzugt vollständig flächendeckend adsorbierten ersten Ausgangsverbindung reagieren, wodurch eine Monolage der zweiten Schicht ausgebildet werden kann. Wie bei einem CVD-Verfahren kann es vorteilhaft sein, wenn die zumindest eine Oberfläche auf eine Temperatur über der Raumtemperatur erhitzt wird. Dadurch kann die Reaktion zur Bildung einer Monolage thermisch initiiert werden. Die Oberflächentemperatur, die beispielsweise auch die Bauelementtemperatur, also die Temperatur des Bauelements, sein kann, kann dabei von den Edukten, also der ersten und zweiten Ausgangsverbindung, abhängen. Durch Wiederholen dieser Verfahrensschritte kann nacheinander eine Mehrzahl von Monolagen aufeinander aufgebracht werden. Dabei ist es für die Herstellung der hier beschriebenen Verkapselungsanordnung vorteilhaft, wenn die Anordnungen der Materialien beziehungsweise Ausgangverbindungen der einzelnen Monolagen unabhängig voneinander von Monolage zu Monolage sind, so dass sich nicht nur lateral entlang der Erstreckungsebene der zu beschichtenden Oberfläche sondern auch in die Höhe eine amorphe Volumenstruktur ausbilden kann.

Die erste und zweite Ausgangsverbindung können beispielsweise im Zusammenhang mit den weiter oben genannten Materialien für die zweite Schicht metallorganische Verbindungen wie etwa Trimethylmetallverbindungen sowie Sauerstoff-haltige Verbindungen sein. Zur Herstellung einer zweiten Schicht mit Al₂O₃ können beispielsweise Trimethylaluminium als erste sowie Wasser oder N₂O als zweite Ausgangsverbindung bereitgestellt werden. Alternativ dazu kann auch Wasser oder N₂O als erste Ausgangsverbindung bereitgestellt werden.

Im Falle von Wasser als erste Ausgangsverbindung wurde überraschend festgestellt, dass direkt auf der Oberfläche des Bauelements eine Monolage aus Wasser aufgebracht werden kann, ohne das Bauelement selbst zu schädigen. Vorraussetzung dabei ist, dass die Zeit, die das Wasser auf der Oberfläche des Bauelements verweilen kann, ohne dass die die zweite Ausgangsverbindung zugeführt wird, kleiner sein muss als die Diffusionszeit, die das Wasser benötigt, um in das Bauelement zu diffundieren. Dies kann dann der Fall sein, wenn die ersten und zweiten Ausgangsverbindungen mit einer Taktrate im Bereich von einigen Millisekunden bis zu 10 Millisekunden oder auch einigen 10 Millisekunden abwechselnd zugeführt werden.

Eine plasmalose Variante einer Atomschichtenabscheidung ("plasma-less atomic layer deposition", PLALD) kann dabei ein ALD-Verfahren bezeichnen, für das kein Plasma wie im Folgenden beschrieben erzeugt wird, sondern bei dem zur Bildung der Monolagen die Reaktion der oben genannten Ausgangsverbindungen nur über die Temperatur der zu beschichtenden Oberfläche initiiert wird.

Die Temperatur der zumindest einen Oberfläche und/oder des Bauelements kann bei einem PLALD-Verfahren beispielsweise größer oder gleich 60°C und kleiner oder gleich 120°C sein.

Eine plasmaunterstützte Variante einer Atomschichtabscheidung ("plasma enhanced atomic layer deposition", PEALD) kann ein ALD-Verfahren bezeichnen, bei dem die zweite Ausgangsverbindung bei gleichzeitiger Erzeugung eines Plasmas zugeführt wird, wodurch es wie bei PECVD-Verfahren möglich sein kann, dass die zweite Ausgangsverbindung angeregt wird. Dadurch kann im Vergleich zu einem plasmalosen ALD-Verfahren die Temperatur, auf die die zumindest eine Oberfläche aufgeheizt wird, verringert werden und durch die Plasmaerzeugung dennoch die Reaktion zwischen Ausgangsverbindungen initiiert werden. Die Monolagen können dabei beispielsweise bei einer Temperatur von kleiner als 120°C und bevorzugt kleiner oder gleich 80°C aufgebracht werden. Um weitere Monolagen zu erzeugen, können die Schritte des Zuführens der ersten Ausgangsverbindung und danach des Zuführens der zweiten Ausgangsverbindung wiederholt werden.

Der Grad der Amorphizität der zweiten Schicht kann durch die Wahl geeigneter Ausgangsverbindungen, Temperaturen, Plasmabedingungen und/oder Gasdrücke erfolgen.

Die zweite Schicht kann nach dem Aufbringen eine Dicke von größer oder gleich 1 Nanometer, bevorzugt von größer oder gleich 5 Nanometer und besonders bevorzugt von größer oder gleich 10 Nanometer sowie kleiner oder gleich 500 nm aufgebracht werden. Insbesondere kann die zweite Schicht eine Dicke von kleiner oder gleich 200 Nanometer, bevorzugt kleiner oder gleich 100 Nanometer und besonders bevorzugt von kleiner oder gleich 50 Nanometer aufwiesen. Das kann bedeuten, dass die zweite Schicht größer oder gleich 1 Monolage bevorzugt größer oder gleich 10 Monolagen und kleiner oder gleich 5000 Monolagen der Materialien der zweiten Schicht aufweist. Dabei entspricht eine Monolage üblicherweise etwa einem Zehntel Nanometer. Durch die hohe Dichte und Qualität der zweiten Schicht kann eine solche Dicke ausreichend sein, um einen wirkungsvollen Schutz vor Feuchtigkeit und/oder Sauerstoff für das darunter liegende Bauelement in Kombination mit der ersten Schicht zu gewährleisten. Je geringer die Dicke der zweiten Schicht ist, desto geringer ist der Zeit- und Materialaufwand zur Herstellung der zweiten Schicht, wodurch sich eine hohe Wirtschaftlichkeit ergeben kann. Je dicker die zweite Schicht ist, desto widerstandsfähiger kann die zweite Schicht beispielsweise gegenüber mechanischen Beeinträchtigungen sein und desto größer kann die Beständigkeit der hermetischen Verkapselungseigenschaft der Verkapselungsanordnung sein.

Aufgrund der geringen Dicke der zweiten Schicht kann eine kurze Prozesszeit und damit eine hohe Wirtschaftlichkeit der hier beschriebenen Verkapselungsanordnung gewährleistet sein. Die Verkapselungsanordnung kann insbesondere direkt und unmittelbar auf dem Bauelement angeordnet sein. Das kann bedeuten, dass die erste Schicht der Verkapselungsanordnung direkt und unmittelbar auf dem Bauelement angeordnet ist.

Weiterhin kann die Verkapselungsanordnung eine dritte Schicht aufweisen, die zwischen der ersten Schicht und dem Bauelement angeordnet ist. Die dritte Schicht kann dabei insbesondere ein anorganisches Material wie im Zusammenhang mit der zweiten Schicht beschrieben aufweisen. Weiterhin kann die dritte Schicht amorph sein. Darüber hinaus kann die dritte Schicht eines oder mehrere weitere Merkmale wie im Zusammenhang mit der zweiten Schicht beschrieben aufweisen. Weiterhin können die zweite und die dritte Schicht gleich ausgebildet sein.

Die erste Schicht kann direkt und unmittelbar auf der dritten Schicht angeordnet sein. Weiterhin kann die dritte Schicht direkt auf dem Bauelement angeordnet sein. Die dritte Schicht kann dabei für die erste Schicht eine homogene Aufbringoberfläche unabhängig von der Oberfläche des Bauelements ermöglichen.

Insbesondere kann die Verkapselungsanordnung direkt auf der Oberfläche des Bauelements angeordnet sein. Das kann bedeuten, dass die die erste Schicht oder gegebenenfalls die dritte Schicht direkt und unmittelbar auf der Oberfläche des Bauelements angeordnet sind. Insbesondere kann das bedeuten, dass die Verkapselungsanordnung keine üblicherweise bei kannten Verkapselungen erforderliche organische Planarisierungsschicht aufweist beziehungsweise auf keiner solchen organischen Planarisierungsschicht aufgebracht werden muss. Die Oberfläche des Bauelements kann, wie im Folgenden weiter unten ausgeführt ist, beispielsweise durch eine Elektrode, eine anorganische optische Auskoppelschicht oder eine sonstige funktionale Schicht des Bauelements gebildet werden.

Weiterhin kann die Verkapselungsanordnung eine Mehrzahl von ersten und eine Mehrzahl von zweiten Schichten aufweisen, die abwechselnd übereinander auf dem Bauelement angeordnet sind, wobei von diesen ersten und zweiten Schichten die dem Bauelement am nächsten angeordnete Schicht eine erste Schicht ist. Die ersten und zweiten Schichten der Mehrzahl der ersten beziehungsweise zweiten Schichten können jeweils gleich oder verschieden ausgebildet sein. Eine "Mehrzahl" kann dabei in diesem und in anderen Zusammenhängen in der vorlieben Beschreibung zumindest eine Anzahl von zwei bedeuten. Durch eine derartige Wiederholung des Schichtaufbaus mit der ersten und zweiten Schicht kann die Verkapselung des Bauelements verbessern. Weiterhin kann die mechanische Robustheit der Verkapselungsanordnung erhöht werden. Durch geeignete Wahl der Materialien der jeweiligen ersten und zweiten Schichten können die optischen Eigenschaften der Verkapselungsanordnung angepasst werden.

Weiterhin kann die Vorrichtung eine Mehrzahl von Verkapselungsanordnungen aufweisen, die auf verschiedenen Oberflächen des Bauelements angeordnet sind.

Weiterhin kann die Verkapselungsanordnung eine Schutzschicht auf der zweiten Schicht aufweisen. Dabei kann die Schutzschicht direkt auf der zweiten Schicht angeordnet sein. Insbesondere kann die Schutzschicht einen zusätzlichen mechanischen Schutz der darunter liegenden ersten und zweiten Schichten ermöglichen. Die Schutzschicht kann eine Dicke von größer oder gleich 1 Mikrometer und kleiner oder gleich 100 Mikrometer aufweisen. Insbesondere kann die Schutzschicht eine Dicke von größer oder gleich 5 Mikrometer und bevorzugt eine Dicke von größer oder gleich 10 Mikrometer aufweisen.

Dabei kann die Schutzschicht ein organisches Material aufweisen, insbesondere etwa Kunststoffe wie etwa Siloxane, Epoxide, Acrylate wie zum Beispiel Methylmethacrylate, Imide, Carbonate, Olefine, Styrole, Urethane oder Derivate davon in Form von Monomeren, Oligomeren oder Polymeren und weiterhin auch Mischungen, Copolymere oder Verbindungen damit. Beispielsweise kann die Schutzschicht ein Epoxidharz, Polymethylmethacrylat (PMMA), Polystyrol, Polycarbonat, Polyacrylat, Polyurethan oder ein Silikonharz wie etwa Polysiloxan oder Mischungen daraus umfassen oder sein. Die Schutzschicht kann dabei beispielsweise transparent sein.

Die Schutzschicht kann weiterhin einen Sprühlack aufweisen beziehungsweise als Sprühlack ausgebildet sein, der zumindest eines der vorher genannten Materialien umfasst und der beispielsweise mittels einer Durchlauf-Sprühbelackungsanlage aufgebracht werden kann. Der Sprühlack kann weiterhin ein UVhärtbarer und/oder ein binder- oder lösungsmittelhaltiger Sprühlack sein.

Dadurch dass die erste und zweite Schicht der Verkapselungsanordnung eine hermetische Verkapselung des Bauelements ermöglichen, kann die Schutzschicht auch Materialien aufweisen, die eigentlich unverträglich weil beispielsweise schädigend für das Bauelement sind. So kann die Schutzschicht beispielsweise als Lösung mit Lösungsmittel aufgebracht werden, die für das unverkapselte Bauelement einen schädlichen Einfluss hätten.

Die Oberfläche des Bauelements, auf der die Verkapselungsanordnung angeordnet ist, kann eben oder gekrümmt sein. Weiterhin kann die Oberfläche auch zumindest zwei Oberflächenbereiche aufweisen, die gegeneinander konkav oder konvex zueinander verkippt sind. Die Oberfläche kann dabei auch eine oder mehrere Kanten und/oder Ecken aufweisen. Dazu können beispielsweise zwei oder mehrere der Oberflächenbereiche der Oberfläche eine gemeinsame Kante und/oder Ecke bilden. Weiterhin können auf der Oberfläche des Bauelements wie weiter oben erwähnt Partikel, Schmutz oder Staub angelagert sein, die eine unregelmäßige Oberflächenstruktur bedingen.

Das Bauelement kann ein Substrat aufweisen oder ein Substrat sein. Das Substrat kann dabei beispielsweise als Trägerelement für elektronische Elemente, insbesondere optoelektronische Elemente, geeignet sein. Beispielsweise kann das Substrat Glas, Quarz und/oder ein Halbleitermaterial aufweisen oder daraus sein. Weiterhin kann das Substrat eine Kunststofffolie oder ein Laminat mit einer oder mehreren Kunststofffolien aufweisen oder daraus sein. Der Kunststoff kann eines oder mehrere Polyolefine wie etwa Polyethylen (PE) hoher und niedriger Dichte und Polypropylen (PP) aufweisen. Weiterhin kann der Kunststoff auch Polyvinylchlorid (PVC), Polystyrol (PS), Polyester und/oder bevorzugt Polycarbonat (PC), Polyethylenterephthalat (PET), Polyethersulfon (PES) und/oder Polyethylennaphthalat (PEN) aufweisen.

Weiterhin kann das Substrat Metall, insbesondere etwa eine Metallfolie, aufweisen. Ein eine Metallfolie umfassendes oder ein als Metallfolie ausgeführtes Substrat kann beispielsweise eine Aluminiumfolie, eine Kupferfolie, eine Edelstahlfolie oder eine Kombination oder einen Schichtenstapel daraus aufweisen.

Das Substrat kann eines oder mehrere der oben genannten Materialien aufweisen und dabei transparent, teilweise transparent oder auch opak ausgeführt sein.

Das Substrat kann dabei zumindest in einem Teilbereich empfindlich gegenüber Feuchtigkeit und/oder Sauerstoff oder alternativ oder zusätzlich durchlässig für Feuchtigkeit und/oder Sauerstoff sein. In diesem Fall kann die Oberfläche, auf der die Verkapselungsanordnung angeordnet ist, eine Substratoberfläche in dem empfindlichen und/oder durchlässigen Teilbereich umfassen oder sein. Durch die Verkapselungsanordnung kann somit eine Abdichtung des Substrats gegenüber der Umgebungsatmosphäre erreicht werden, so dass das Substrat einerseits geschützt sein kann. Andererseits kann die Verkapselungsanordnung den durchlässigen Teilbereich des Substrats abdichten, so dass die Vorrichtung umfassend das Substrat mit der Verkapselungsanordnung auch als hermetisch dichtes Substrat ausgebildet sein, auf dem beispielsweise feuchtigkeits- und/oder sauerstoffempfindliche weitere Komponenten aufgebracht werden können.

Im Falle eines feuchtigkeits- und/oder sauerstoffdurchlässigen- und/oder -empfindlichen Substratmaterials kann das Substrat auch gänzlich von der Verkapselungsanordnung umschlossen sein, so dass die Verkapselungsanordnung auf allen Substratoberflächen angeordnet ist. Dadurch können für die Vorrichtung Substratmaterialien genutzt werden, die intrinsisch nicht dicht sind und auf denen weitere Elemente wie unten im Zusammenhang mit dem Bauelement beschrieben aufgebracht werden können.

Beispielsweise kann das Substrat eine Kunststofffolie aufweisen oder aus einer solchen sein, die hinsichtlich ihrer mechanischen Eigenschaften wie etwa Flexibilität geeignet für die Vorrichtung sein kann. Dabei kann aber der Kunststoff des Substrats beispielsweise durchlässig für Feuchtigkeit und/oder Sauerstoff sein und/oder eine für die Vorrichtung und/oder das Bauelement ungeeignet hohe Wasserdiffusionsrate aufweisen. Durch die Anordnung der Verkapselungsanordnung auf einer oder bevorzugt auf allen Oberflächen des Substrats dieses weiterhin seine mechanischen Eigenschaften aufweisen und gleichzeitig durch die Verkapselungsanordnung dicht gegenüber Feuchtigkeit und/oder Sauerstoff sein.

Weiterhin kann das Substrat auch zumindest eine erste Substratschicht und eine zweite Substratschicht aufweisen, wobei beispielsweise die die zweite Substratschicht durchlässig und/oder empfindlich gegenüber Feuchtigkeit und/oder Sauerstoff ist, während die erste Substratschicht undurchlässig für und unempfindlich gegenüber Feuchtigkeit und/oder Sauerstoff ist. Die Verkapselungsanordnung kann in diesem Fall über oder direkt auf der zweiten Substratschicht angeordnet sein, so dass die erste und zweite Substratschicht gänzlich von der Verkapselungsanordnung umschlossen sind oder so dass die zweite Substratschicht zusammen von der Verkapselungsanordnung und der ersten Substratschicht gänzlich umschlossen ist.

Die erste Substratschicht kann beispielsweise eine Metallfolie sein, auf der die zweite Substratschicht in Form einer planarisierenden Kunststoffschicht mit einem Kunststoff aufgebracht ist, der beispielsweise durchlässig gegenüber Feuchtigkeit und/oder Sauerstoff ist. Eine derartige planarisierende Kunststoffschicht kann insbesondere wegen einer für Bauelemente, wie sie im Folgenden beschrieben sind, ungeeignet hohen Rauhigkeit vorteilhaft sein. Durch die Verkapselungsanordnung kann eine ungeeignet hohe Wasserleitfähigkeit beziehungsweise -durchlässigkeit der Kunststoffschicht wiederum verhindert werden. Eine als planarisierende Kunststoffschicht ausgebildete zweite Substratschicht kann eines der oben genannten Kunststoffmaterialien und alternativ oder zusätzlich auch weitere Polymere, insbesondere fluorierte Polymere, Parylene, Cyclotene, Polyacrylate und Kombinationen oder Schichtenfolgen aufweisen.

Weiterhin kann das Bauelement als elektronisches Bauelement ausgebildet sein. Insbesondere kann das Bauelement eine anorganische lichtemittierende Diode (LED), organische lichtemittierende Diode (OLED), eine anorganische Photodiode (PD), eine organische Photodiode (OPD), eine anorganische Solarzelle (SC), eine organische Solarzelle (OSC), einen anorganischen Transistor, insbesondere einen anorganischen Dünnfilmtransistor (TFT), einen organischen Transistor, insbesondere einen organischen Dünnfilmtransistor (OTFT), einen integrierten Schaltkreis (IC) oder eine Mehrzahl oder Kombination aus den genannten Elementen aufweisen oder derart ausgebildet sein.

Ein als elektronisches Bauelement ausgeführtes Bauelement kann beispielsweise ein Substrat aufweisen. Das Substrat kann dabei gemäß der obigen Beschreibung ausgeführt sein. Weiterhin kann das Substrat bereits als Vorrichtung gemäß der vorliegenden Beschreibung mit einer ersten Verkapselungsanordnung ausgeführt sein. Die als Substrat ausgeführte Vorrichtung kann somit als hermetisch dichtes Substrat für das Bauelement einer übergeordneten Vorrichtung dienen, die eine zweite Verkapselungsanordnung gemäß der vorliegenden Beschreibung zur Verkapselung beispielsweise funktioneller Bereiche und/oder Schichten des Bauelements aufweist.

Das Bauelement kann weiterhin eine funktionelle Schichtenfolge mit zumindest einer ersten und einer zweiten Elektrode aufweisen, zwischen denen eine oder mehrere anorganische und/oder organische funktionelle Schichten angeordnet sind. Insbesondere kann die funktionelle Schichtenfolge auf einem Substrat angeordnet sein.

Weist das Bauelement beispielsweise eine LED, eine OLED, eine PD, eine OPD, eine SC und/oder eine OSC auf, kann die funktionelle Schichtenfolge einen aktiven Bereich aufweisen, der geeignet ist, im Betrieb des Bauelements beziehungsweise der Vorrichtung elektromagnetische Strahlung zu erzeugen oder zu detektieren. Weiterhin kann das Bauelement ein transparentes Substrat aufweisen. Ferner kann alternativ oder zusätzlich auch die Verkapselungsanordnung zumindest teilweise transparent für die im Betrieb abgestrahlten oder detektierte elektromagnetische Strahlung sein.

Weiterhin können die erste Elektrode und/oder die zweite Elektrode transparent sein und beispielsweise ein transparentes leitendes Oxid aufweisen oder aus einem transparenten leitenden Oxid bestehen. Eine Elektrode mit einem derartigen Material kann insbesondere als Anode, also als löcherinjizierendes Material, ausgebildet sein. Transparente leitende Oxide (transparent conductive oxides, kurz "TCO") sind transparente, leitende Materialien, in der Regel Metalloxide, wie beispielsweise Zinkoxid, Zinnoxid, Cadmiumoxid, Titanoxid, Indiumoxid oder Indiumzinnoxid (ITO). Neben binären Metallsauerstoffverbindungen, wie beispielsweise ZnO, SnO₂ oder In₂O₃ gehören auch ternäre Metallsauerstoffverbindungen, wie beispielsweise Zn₂SnO₄, CdSnO₃, ZnSnO₃, MgIn₂O₄, GaInO₃, Zn₂In₂O₅ oder In₄Sn₃O₁₂ oder Mischungen unterschiedlicher transparenter leitender Oxide zu der Gruppe der TCOs. Weiterhin entsprechen die TCOs nicht zwingend einer stöchiometrischen Zusammensetzung und können auch p- oder n-dotiert sein.

Weiterhin können die erste und/oder die zweite Elektrode ein Metall aufweisen, das beispielsweise als Kathodenmaterial, also als elektroneninjizierendes Material, dienen kann. Als Kathodenmaterial können sich unter anderem insbesondere Aluminium, Barium, Indium, Silber, Gold, Magnesium, Kalzium oder Lithium sowie Verbindungen, Kombinationen und Legierungen davon als vorteilhaft erweisen. Alternativ oder zusätzlich kann eine oder können beide Elektroden auch Kombinationen, insbesondere Schichtenfolgen aus TCOs und/oder Metallen aufweisen.

Die eine oder mehreren funktionellen Schichten können organische Polymere, organische Oligomere, organische Monomere, organische kleine, nicht-polymere Moleküle ("small molecules") oder Kombinationen daraus aufweisen. Insbesondere kann es vorteilhaft sein, wenn ein als organisches elektronisches Bauelement ausgeführtes Bauelement mit einer OLED, OPD, OSC und/oder einem OTFT eine funktionelle Schicht aufweist, die als Lochtransportschicht ausgeführt ist, um beispielsweise im Falle einer OLED eine effektive Löcherinjektion in eine elektrolumineszierende Schicht oder einen elektrolumineszierenden Bereich zu ermöglichen. Als Materialien für eine Lochtransportschicht können sich beispielsweise tertiäre Amine, Carbazolderivate, leitendes Polyanilin oder Polyethylendioxythiophen als vorteilhaft erweisen. Weiterhin kann es vorteilhaft sein, wenn eine funktionelle Schicht als elektrolumineszierende Schicht ausgeführt ist. Als Materialien hierzu eignen sich Materialien, die eine Strahlungsemission aufgrund von Fluoreszenz oder Phosphoreszenz aufweisen, beispielsweise Polyfluoren, Polythiophen oder Polyphenylen oder Derivate, Verbindungen, Mischungen oder Copolymere davon. Abhängig von den Materialien in den funktionellen Schichten kann die erzeugte erste Strahlung einzelne Wellenlängen oder Bereiche oder Kombinationen daraus aus dem ultravioletten bis rotem Spektralbereich aufweisen.

Weist das Bauelement eine LED, PD, SC und/oder einen TFT auf, können die eine oder mehreren funktionalen Schichten eine Epitaxieschichtenfolge, eine epitaktisch gewachsene Halbleiterschichtenfolge, aufweisen oder als solche ausgeführt sein. Dabei kann die Halbleiterschichtenfolge beispielsweise einen III-V-Verbindungshalbleiter auf der Basis von InGaAlN, InGaAlP und/oder AlGAs und/oder eine II-VI-Verbindungshalbleiter mit einem oder mehreren der Elemente Be, Mg, Ca und Sr sowie einem oder mehreren der Element O, S und Se aufweisen. Beispielsweise gehören zu den II-VI-Verbindungshalbleitermaterialien ZnO, ZnMgO, CdS, ZnCdS und MgBeO.

Ein eine oder mehrere OLEDs und/oder eine oder mehrere LEDs aufweisendes Bauelement kann insbesondere als Beleuchtungseinrichtung oder als Display ausgebildet sein und eine großflächig ausgebildete aktive Leuchtfläche aufweisen. "Großflächig" kann dabei bedeuten, dass das Bauelement eine Fläche von größer oder gleich einigen Quadratmillimetern, bevorzugt größer oder gleich einem Quadratzentimeter und besonders bevorzugt größer oder gleich einem Quadratdezimeter aufweist.

Die genannte Aufzählung der Ausführungsformen des Bauelements ist nicht beschränkend zu verstehen. Vielmehr kann das Bauelement weitere elektronische Elemente und/oder funktionelle Schichtenfolgen aufweisen, die dem Fachmann bekannt sind und die daher hier nicht weiter ausgeführt werden.

Die Verkapselungsanordnung kann auf einer oder mehreren Oberflächen der vorab beschriebenen funktionellen Schichtenfolgen angeordnet sein. Weist das Bauelement ein Substrat auf, auf dem die funktionelle Schichtenfolge angeordnet ist, so kann sich die Verkapselungsanordnung über zumindest einen Teilbereich des Substrats und die funktionelle Schichtenfolge erstrecken, so dass die funktionelle Schichtenfolge vom Substrat und der Verkapselungsanordnung gänzlich umschlossen ist. Weist das Bauelement ein wie oben beschriebenes feuchtigkeits- und/oder sauerstoffdurchlässiges und/oder -empfindliches Substrat auf, kann das Bauelement gänzlich von der Verkapselungsanordnung umschlossen sein. Das kann bedeuten, dass das die Verkapselungsanordnung auf allen freiliegenden Oberflächen des Bauelements und damit auf allen freiliegenden Oberflächen des Substrats und der funktionellen Schichtenfolge angeordnet ist.

Alternativ oder zusätzlich kann direkt auf dem Substrat eine erste Verkapselungsanordnung angeordnet sein, mittels derer das Substrat verkapselt ist. Auf dem derart verkapselten Substrat kann die funktionelle Schichtenfolge angeordnet sein und mittels einer zweiten Verkapselungsanordnung verkapselt sein. die erste und zweite Verkapselungsanordnung können dabei gleich oder verschieden voneinander ausgeführt sein und eines oder mehrere der oben genannten Merkmale aufweisen.

Weiterhin kann das Bauelement beispielsweise einen Abdeckung in Form eines Deckels über einem Substrat mit der funktionalen Schichtenfolge aufweisen. Die Verkapselungsanordnung kann beispielsweise zwischen der Abdeckung und dem Substrat angeordnet sein. Die Abdeckung kann insbesondere beispielsweise mittels eines um die funktionale Schichtenfolge umlaufenden Verbindungsmaterials, etwa eines Glaslots, Glasfritten und/oder eines Klebstoffs, auf das Substrat auflaminiert sein. Die Verkapselungsanordnung kann dabei umlaufend auf dem Verbindungsmaterial und/oder auf dem Substrat und/oder auf der Abdeckung angeordnet sein. Dadurch kann es möglich sein, dass mögliche Permeationspfade für Feuchtigkeit und/oder Sauerstoff durch das Verbindungsmaterial und/oder entlang der Grenzflächen zwischen dem Verbindungsmaterial und dem Substrat und/oder der Abdeckung abgedichtet werden können.

Die hier beschriebenen Vorrichtungen und Verkapselungsanordnungen können dabei auch bei extremen Umgebungsbedingungen hermetisch dicht sein. Beispielsweise können die hier beschriebenen Vorrichtungen und Verkapselungsanordnungen bei einer erhöhten Temperatur, beispielsweise größer oder gleich 40°C, größer oder gleich 60°C und insbesondere auch größer oder gleich 85°C, und bei relativen Luftfeuchtigkeiten von größer oder gleich 85% und insbesondere größer oder gleich 90% für mehr als 500 Stunden hermetisch dicht sein. Derartige Anforderungen werden beispielsweise an Vorrichtungen für Automobilanwendungen gestellt, die nach dem Fachmann bekannten Automobilnormen wie etwa der Norm AEC Q101 oder deren Grundnorm JEDEC JESD22-A101 oder auch der Norm IEC 68-2-78 gefordert werden. Typische Testbedingungen, die von diesen Normen abgeleitet werden können, sind dabei beispielsweise 60°C, 90% relative Luftfeuchtigkeit, 85°C, 85% relative Luftfeuchtigkeit oder auch 440°C, 93% relative Luftfeuchtigkeit, unter denen zu testende Vorrichtungen mehr als 12 Stunden, 16 Stunden, 24 Stunden, 2, 4, 10, 21 oder auch 56 Tage funktionsfähig bleiben müssen. Im Hinblick auf die hier beschriebenen Verkapselungsanordnungen bedeutet dies, dass diese unter den genannten Bedingungen hermetisch dicht bleiben.

Beispielsweise können die hier beschriebenen Verkapselungsanordnung länger als 500 Stunden hermetisch dicht bei einer Temperatur von größer oder gleich 60°C und einer relativen Luftfeuchtigkeit von größer oder gleich 85% oder auch bei einer der vorab genannten Bedingungen sein.

Gemäß den oben genannten Ausführungsformen wurde beispielsweise eine Vorrichtung mit einer Verkapselungsanordnung auf einem als OLED ausgeführten Bauelement hergestellt und in einem Feuchtetest auf Dichtigkeit geprüft. Die OLED wies dabei eine aktive Fläche von 1 Quadratzentimeter auf, die im Betrieb der Vorrichtung als leuchtende Fläche ("Leuchtbild") wahrgenommen werden konnte. Durch die Verkapselungsanordnung konnte erreicht werden, dass bei einer Umgebungstemperatur von 60°C und 90% relativer Luftfeuchtigkeit auch nach 504 Stunden im Leuchtbild der aktiven Fläche keinerlei neue schwarze Flecken entstanden beziehungsweise bereits nach der Fertigung der OLED vorhandene schwarze Flecken nicht wuchsen. Als schwarze Flecken werden hierbei zumeist kreisrunde Gebiete im Leuchtbild bezeichnet, die bei Anlegen einer Spannung nicht (mehr) leuchten und daher gegenüber ihrer leuchtenden Umgebung dunkel beziehungsweise schwarz erscheinen.

Somit kann die hier beschriebene Verkapselungsanordnung eine Defektdichte von weniger als einem Defekt pro Quadratzentimeter aufweisen.

Weitere Vorteile und vorteilhafte Ausführungsformen und Weiterbildungen der Erfindung ergeben sich aus den im Folgenden in Verbindung mit den Figuren 1 bis 16E beschriebenen Ausführungsformen.

Es zeigen:
Figur 1 eine schematische Darstellung einer Vorrichtung nicht gemäß der vorliegenden Erfindung,
Figuren 2 bis 14 schematische Darstellungen von Vorrichtungen gemäß weiteren Ausführungsbeispielen und
Figur 15 bis 16C eine schematische Darstellungen von Ausschnitten aus Verkapselungsanordnungen gemäß weiteren Ausführungsbeispielen.

In den Ausführungsbeispielen und Figuren können gleiche oder gleich wirkende Bestandteile jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente, wie zum Beispiel Schichten, Bauteile, Bauelemente und Bereiche, zur besseren Darstellbarkeit und/oder zum besseren Verständnis übertrieben dick oder groß dimensioniert dargestellt sein.

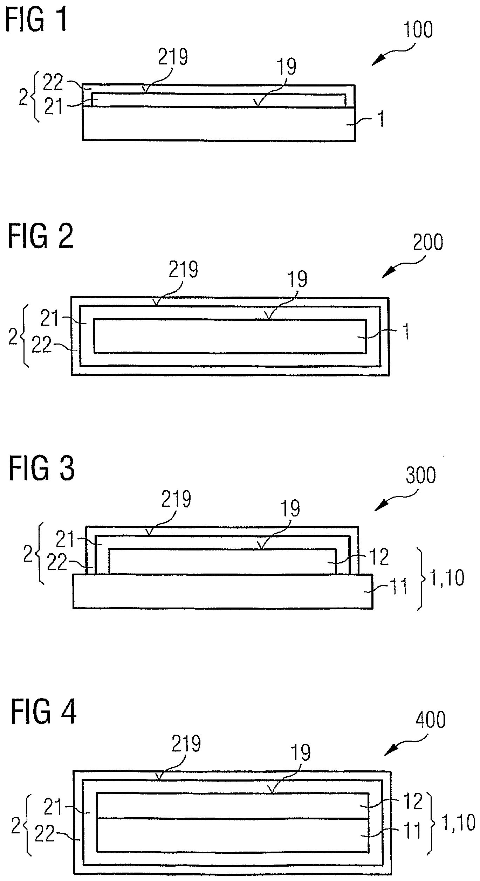

In Figur 1 ist eine Vorrichtung 100 gemäß einem Ausführungsbeispiel gezeigt welches nicht gemäß der Erfindung ist. Die Vorrichtung 100 weist ein Bauelement 1 auf, das im gezeigten Ausführungsbeispiel rein schematisch angedeutet ist und gemäß der Beschreibung im allgemeinen Teil ausgeführt sein kann. Insbesondere weist das Bauelement 1 eine Oberfläche 19 auf, die empfindlich gegenüber Feuchtigkeit und/oder Sauerstoff ist.

Auf der Oberfläche 19 des Bauelements 1 ist eine Verkapselungsanordnung 2 angeordnet. Die Verkapselungsanordnung 2 weist eine erste Schicht 21 und darüber eine zweite Schicht 22 auf. Die erste Schicht 21 ist im gezeigten Ausführungsbeispiel mittels eines PECVD-Verfahrens direkt auf der Oberfläche 19 des Bauelements aufgebracht und ist aus einen anorganischen Material, das Siliziumnitrid aufweist. Durch das PECVD-Verfahren wird die erste Schicht 21 mit einer kristallinen bis polykristallinen Volumenstruktur erzeugt, die im gezeigten Ausführungsbeispiel eine Dicke von einigen hundert Nanometern aufweist. Alternativ dazu kann die erste Schicht auch andere, im allgemeinen Teil beschriebene Materialien aufweisen, die beispielsweise auch mittels der oben genannten weiteren Aufbringverfahren auf der Oberfläche 19 des Bauelements 1 aufgebracht werden können.

Direkt auf der dem Bauelement 1 abgewandten Oberfläche 219 der ersten Schicht 21 ist die zweite Schicht 22 aufgebracht. Die Oberfläche 219 bildet damit die Grenzfläche zwischen der ersten und zweiten Schicht. Die zweite Schicht 22 weist ein anorganisches Material auf und ist im gezeigten Ausführungsbeispiel insbesondere aus Aluminiumoxid. Das Aluminiumoxid ist mittels eines im allgemeinen Teil näher beschriebenen Atomschichtenabscheideverfahrens aufgebracht, das hinsichtlich der Verfahrensparameter derart angepasst ist, dass die zweite Schicht eine Volumenstruktur aufweist, die unabhängig von der Volumenstruktur der ersten Schicht ausgebildet ist. Das bedeutet, dass sich die im gezeigten Ausführungsbeispiel vorliegende kristalline bis polykristalline Volumenstruktur der ersten Schicht 21 nicht in Form einer epitaktischen oder epitaxieähnlichen Weise in der zweiten Schicht 22 fortsetzt und damit keinen Einfluss auf die Volumenstruktur der zweiten Schicht 22 hat. Dabei ist die zweite Schicht 22 derart ausgeführt, dass die Volumenstruktur der zweiten Schicht 22 eine größere Amorphizität als die Volumenstruktur der ersten Schicht 21 aufweist. Insbesondere ist die zweite Schicht 22 im gezeigten Ausführungsbeispiel amorph und weist keine nachweisbare Kristallinität auf.

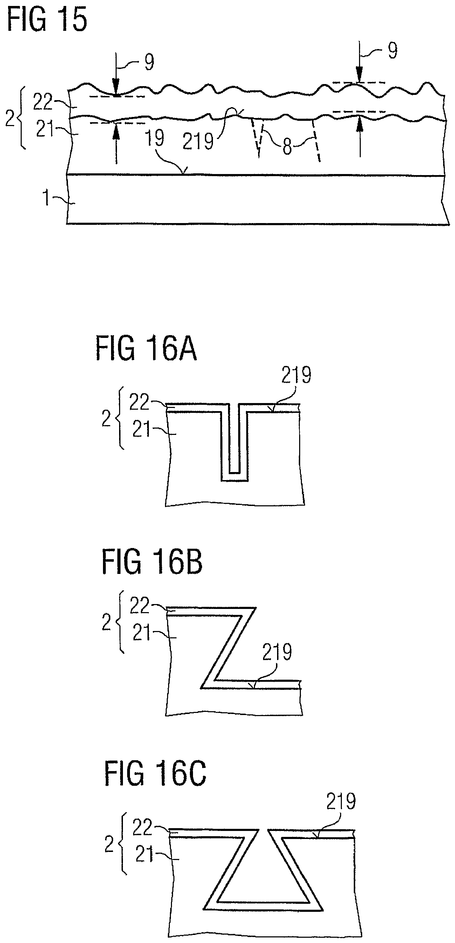

In diesem Zusammenhang ist in Figur 15 ein Ausschnitt der Vorrichtung 100 gezeigt, in dem die Verkapselungsanordnung 2 mit der ersten und zweiten Schicht 21, 22 vergrößert dargestellt sind. Wie aus Figur 15 ersichtlich ist, weist die Oberfläche 219 der ersten Schicht 21, auf der die zweite Schicht 22 aufgebracht ist, eine Oberflächenstruktur in Form einer Rauhigkeit auf, die beispielsweise durch das Aufbringverfahren, mit dem die erste Schicht 21 auf dem Bauelement 1 aufgebracht wird, bedingt ist.

Weiterhin weist die Volumenstruktur der ersten Schicht 21 Struktur- beziehungsweise Gitterfehler 8 wie etwa Poren oder Versetzungen auf, die lediglich schematisch und rein beispielhaft angedeutet sind. Die Struktur- und Gitterfehler 8 können sich dabei wie gezeigt bis zur Oberfläche 219, also bis zur Grenzfläche zwischen der ersten und zweiten Schicht 21, 22, fortsetzen. Die Struktur- und Gitterfehler 8 können beispielsweise auch durch Partikel und/oder Verunreinigungen auf der Oberfläche 19 hervorgerufen werden, die beim Aufbringen der ersten Schicht 21 einen Bereich der Oberfläche 19 abdecken und/oder abschatten können, wodurch eine ungleichmäßige Aufbringung der ersten Schicht 21 mit einer erhöhten Neigung zur Ausbildung von Struktur- und Gitterfehlern 8 bedingt werden kann.

Die zweite Schicht 22 ist derart ausgebildet, dass derartige Struktur- und Gitterfehler 8 keinen Einfluss auf die Volumenstruktur der zweiten Schicht 22 haben. Die zweite Schicht 22 ist somit mit einer gleichmäßig amorphen Volumenstruktur ausgebildet und deckt die erste Schicht 21 gänzlich ab, wodurch auch mögliche durch Gitter- und Strukturfehler 8 der Volumenstruktur der ersten Schicht 21 gebildete Permeationspfade für Feuchtigkeit und/oder Sauerstoff abgedichtet werden. Dadurch kann mittels der Verkapselungsanordnung 2 und insbesondere mittels der Kombination der ersten und zweiten Schicht 21, 22 eine hermetische Verkapselung des Bauelements 1 und insbesondere der Oberfläche 19 gegenüber Feuchtigkeit und/oder Sauerstoff ermöglicht werden.

Die zweite Schicht 22 weist weiterhin eine Dicke auf, die rein beispielhaft an zwei Stellen mit den Bezugzeichen 9 gekennzeichnet ist. Wie in Figur 15 erkennbar ist, folgt die zweite Schicht 22 der Oberflächenstruktur der Oberfläche 219 der ersten Schicht in der im allgemeinen Teil beschriebenen Weise, so dass die Dicke 9 der zweiten Schicht 22 nahezu unabhängig von der Oberflächenstruktur der ersten Schicht 21 ist.

Das bedeutet insbesondere, dass sowohl die Volumenstruktur als auch die Dickenvariation der Dicke 9 der zweiten Schicht 22 zumindest nahezu unabhängig von der Volumenstruktur und unabhängig von der Oberflächenstruktur der ersten Schicht 21 sind. Dabei beträgt die Dickenvariation der Dicke 9 weniger als 10%. Wie in Figur 15 gezeigt ist, ist die zweite Schicht 22 derart ausgebildet, dass sie den mikroskopischen Strukturen der Oberflächenstruktur der ersten Schicht 21 zumindest nahezu folgen kann.

Gemäß den Figuren 16A bis 16C sind in diesem Zusammenhang weitere Ausschnitte einer Verkapselungsanordnung 2 gezeigt, in denen die erste Schicht 21 Oberflächenstrukturen mit rein beispielhaft gezeigten makroskopischen Strukturen aufweist. In Figur 16A weist die erste Schicht 21 in der Oberfläche 219 eine Öffnung beziehungsweise Vertiefung auf, die ein Tiefezu-Durchmesser-Verhältnis von größer als 1 aufweist. Die zweite Schicht 22 folgt der Oberflächenstruktur der ersten Schicht 22 und kleidet dabei die Oberfläche der Öffnung mit nahezu gleich bleibender Dicke aus. Dabei kann das Tiefe-zu-Durchmesser-Verhältnis der Öffnung in der ersten Schicht 21 größer oder gleich 10 und besonders bevorzugt auch größer oder gleich 30 sein.

In Figur 16B weist die Oberfläche 219 der ersten Schicht 21 einen überhängenden Teilbereich auf, während die erste Schicht 21 in Figur 16C eine sich nach unten verbreitende Öffnung aufweist. Trotz der negativen Winkel zum Aufbringen der zweiten Schicht 22 auf derartige Strukturen der Oberflächenstruktur der ersten Schicht 21 kann die zweite Schicht mit einer nahezu gleich bleibenden Dicke wie in Figur 15 gezeigt ausgebildet werden.

Alternativ oder zusätzlich zu den in den Figuren 15 bis 16C gezeigten Strukturen kann die erste Schicht 21 und insbesondere die Oberfläche 219 der ersten Schicht 21 weitere, wie im allgemeinen Teil beschriebene Strukturen beziehungsweise Oberflächenstrukturen aufweisen.

Dadurch, dass die Volumenstruktur und die Dicke der zweiten Schicht 22 zumindest nahezu unabhängig von der Volumen- und der Oberflächenstruktur der ersten Schicht sind, kann eine gleichmäßige, homogene und gänzlich bedeckende Anordnung der zweiten Schicht 22 auf der ersten Schicht ermöglicht werden. Dadurch kann die Verkapselungsanordnung 2 die Vorteile der ersten Schicht 21 in Kombination mit den Vorteilen der zweiten Schicht 22 aufweisen.

Im Folgenden werden weitere Ausführungsbeispiele von Vorrichtungen gezeigt, die Modifikationen der in Verbindung mit den Figuren 1 und 15 bis 16C gezeigten Ausführungsbeispiele darstellen.

In Figur 2 ist eine Vorrichtung 200 gemäß einem weiteren Ausführungsbeispiel gezeigt, bei der die Verkapselungsanordnung 2 das Bauelement 1 gänzlich umgibt und umschließt. Das bedeutet, dass die Oberfläche 19 des Bauelements 1, auf der die erste Schicht 21 und die zweite Schicht 22 angeordnet sind, alle Oberflächen des Bauelements 1 umfasst. Durch die erste und zweite Schicht 21, 22 kann somit eine Verkapselungsanordnung 2 ermöglicht werden, die auch auf verschiedenen gegeneinander geneigten und verkippten Oberflächen angeordnet werden kann und die sich auch über Ecken und Kanten erstrecken kann.

Das Bauelement 1 der Figur 2 kann beispielsweise eine an sich für Feuchtigkeit und Sauerstoff durchlässige, flexible Kunststofffolie sein, die beispielsweise als flexibles Substrat für ein elektronisches Bauelement dienen soll. Durch die allseitig angeordnete Verkapselungsanordnung 2, die sich über alle Oberflächen, Ecken und Kanten des Bauelements 1 erstreckt, ist die gezeigte Vorrichtung 200 als flexibles, hermetisch dichtes Substrat ausgebildet.

In Figur 3 ist eine Vorrichtung 300 gemäß einem weiteren Ausführungsbeispiel gezeigt, das wie im vorangegangenen Ausführungsbeispiel beispielsweise ein als Substrat 10 ausgebildetes Bauelement 1 aufweist. Das Substrat 10 weist eine erste Substratschicht 11 und darauf eine zweite Substratschicht 12 auf. Die erste Substratschicht 11 ist als Metallfolie, etwa als Edelstahlfolie, ausgebildet, die eine ausreichende Dicke aufweist, um dicht gegenüber Feuchtigkeit und Sauerstoff zu sein. Derartige Metallfolien sind aufgrund ihrer Flexibilität, Dichtigkeit, Stabilität und elektrischen Leitfähigkeit gut als Substratmaterialien für elektronische Bauelemente wie etwa flexible OLEDs und/oder flexible OPVs geeignet. Jedoch weisen Metallfolien üblicherweise eine relativ hohe Oberflächenrauhigkeit auf, die entweder ein aufwändiges und kostenintensives Glättungsverfahren oder eine Planarisierungsschicht erforderlich machen.

Im gezeigten Ausführungsbeispiel weist die zweite Substratschicht 12 ein im allgemeinen Teil genanntes Polymer auf, das geeignet ist, die als Metallfolie ausgebildete erste Substratschicht 11 zu planarisieren. Da derartige Polymere jedoch üblicherweise durchlässig für Feuchtigkeit und/oder Sauerstoff sein können, ist auf der durch die zweite Substratschicht 12 gebildete Oberfläche 19 des Substrats 10 eine Verkapselungsanordnung 2 mit einer ersten und einer zweiten Schicht angeordnet. Dadurch können die zweite Substratschicht 12 und damit auch das Substrat 10 beziehungsweise das Bauelement 1 hermetisch gegen Feuchtigkeit und Sauerstoff abgedichtet und verkapselt werden, so dass die Vorrichtung 300 ebenfalls als flexibles, hermetisch dichtes Substrat dienen kann. Weisen die erste und die zweite Schicht 21, 22 elektrisch leitende oder elektrisch halbleitende Materialien wie im allgemeinen Teil beschrieben auf, so kann die Vorrichtung 300 zusätzlich als elektrisch leitendes Substrat dienen.

In Figur 4 ist eine Vorrichtung 400 gemäß einem weiteren Ausführungsbeispiel gezeigt, bei der ein als Substrat 10 ausgebildetes Bauelement 1 eine erste und eine zweite Substratschicht 11, 12 aufweist. Die Verkapselungsanordnung 2 mit der ersten und zweiten Schicht 21, 22 ist auf allen freiliegenden Oberflächen der ersten und zweiten Substratschicht 11, 12 angeordnet und umschließt und verkapselt das Bauelement 1 im gezeigten Ausführungsbeispiel somit gänzlich.

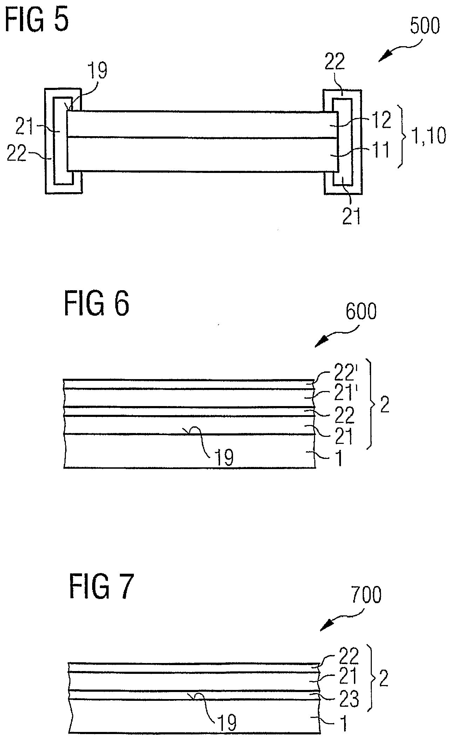

In Figur 5 ist eine Vorrichtung 500 gemäß einem weiteren Ausführungsbeispiel gezeigt, bei der ein als Substrat 10 ausgebildetes Bauelement 1 ebenfalls eine erste und eine zweite Substratschicht 11, 12 aufweist. Die Oberfläche 19 des Bauelements 1, auf der die Verkapselungsanordnung 2 aufgebracht ist, umfasst im gezeigten Ausführungsbeispiel einen Randbereich des Bauelements 1 und deckt insbesondere die Verbindungsfläche bzw. den Verbindungsspalt zwischen der ersten und zweiten Substratschicht 11, 12 ab. Dadurch kann beispielsweise Verbindungsmaterial wie etwa ein Klebstoff, mittels dessen die erste und zweite Substratschicht 11, 12 aufeinander laminiert werden, vor Feuchtigkeit und/oder Sauerstoff verkapselt und geschützt werden.

Zusätzlich zu den als Substrate ausgeführten Bauelementen 1 in den vorangegangenen Ausführungsbeispielen können diese auch weitere Merkmale von Bauelementen gemäß dem allgemeinen Teil der Beschreibung aufweisen.

In Figur 6 ist ein Ausschnitt einer Vorrichtung 600 gemäß einem weiteren Ausführungsbeispiel gezeigt, die im Vergleich zu den bisher gezeigten Ausführungsbeispielen auf einer Oberfläche 19 des Bauelements 1 eine Verkapselungsanordnung 2 mit einer Mehrzahl von ersten Schichten und einer Mehrzahl von zweiten Schichten aufweist. Dabei sind die ersten Schichten 21, 21' und die zweiten Schichten 22, 22' abwechselnd aufeinander angeordnet, beginnend mit der ersten Schicht 21 auf der Oberfläche 19 des Bauelements 1. Zusätzlich zu den gezeigten jeweils zwei ersten und zwei zweiten Schichten 21, 21', 22, 22' kann die Verkapselungsanordnung 2 noch weitere erste und zweite Schichten aufweisen.

Die ersten und zweiten Schichten 21, 21', 22, 22' können jeweils gleich oder auch verschieden voneinander ausgebildet sein und beispielsweise auch verschiedene Materialien mit verschiedenen optischen Eigenschaften wie etwa verschiedenen Brechungsindizes aufweisen. Durch die Wiederholung der Schichtkombination aus erster und zweiter Schicht 21, 22 beziehungsweise 21' ,22' kann auch die mechanische Robustheit der Verkapselungsanordnung 2 erhöht werden.

In Figur 7 ist ein Ausschnitt einer Vorrichtung 700 gemäß einem weiteren Ausführungsbeispiel gezeigt, die eine Verkapselungsanordnung 2 mit einer dritten Schicht 23 zusätzlich zur ersten und zweiten Schicht 21, 22 aufweist. Die dritte Schicht 23 ist dabei zwischen der ersten Schicht 21 und dem Bauelement 1 direkt auf der Oberfläche 19 des Bauelements 1 angeordnet. Die dritte Schicht 23 weist ein anorganisches Material auf, das beispielsweise gleich dem Material der zweiten Schicht 22 sein kann und das hinsichtlich seiner Volumenstruktur und der Dickevariation wie die zweite Schicht 22 ausgebildet ist. Insbesondere ist die dritte Schicht 23 derart ausgebildet, dass sie der Oberflächenstruktur der Oberfläche 19 des Bauelements 1 folgt und eine amorphe Volumenstruktur aufweist.

Durch die dritte Schicht kann beispielsweise eine konforme Schicht beziehungsweise Oberfläche zur Anordnung der ersten Schicht 21 bereitgestellt werden, wodurch die Qualität der ersten Schicht 21 erhöht werden kann.

Alle vorab und im Weiteren gezeigten Ausführungsbeispiele weisen erfindungsgemäß in den gezeigten Verkapselungsanordnungen gemäß der Figuren 6 und/oder 7 eine Mehrzahl von ersten und zweiten Schichten 21, 21', 22, 22' und/oder eine dritte Schicht 23 auf.

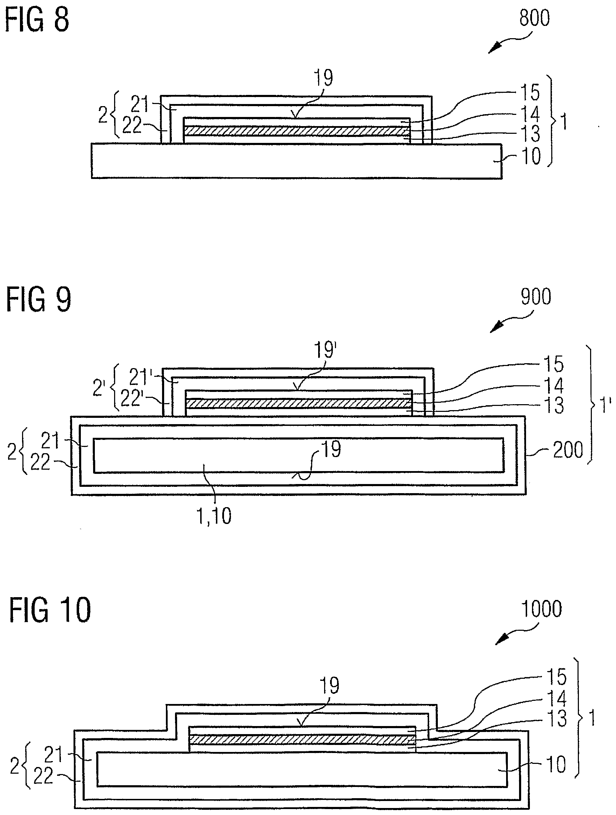

In den folgenden Figuren 8 bis 14 sind Vorrichtungen mit Bauelementen 1 gezeigt, die rein beispielhaft als OLEDs ausgebildet sind. Alternativ oder zusätzlich dazu können die Bauelemente 1 auch Merkmale anderer im allgemeinen Teil beschriebener elektrischer Bauelemente aufweisen.

Die Bauelemente 1 der folgenden Ausführungsbeispiele weisen auf einem Substrat funktionelle Schichten auf, von denen jeweils rein exemplarisch eine erste und eine zweite Elektrode 13 und 15 gezeigt sind, zwischen denen organische funktionelle Schichten 14 mit einem aktiven Bereich angeordnet sind. Der aktive Bereich ist geeignet, im Betrieb der jeweiligen Vorrichtung beziehungsweise des jeweiligen Bauelements elektromagnetische Strahlung abzustrahlen. Dabei können die als OLEDs ausgeführten Bauelement 1 beispielsweise ein transparentes Substrat und eine transparente, auf dem Substrat unterhalb der organischen funktionellen Schichten 14 angeordnete erste Elektrode 13 aufweisen, so dass die im aktiven Bereich erzeugte elektromagnetische Strahlung durch das Substrat abgestrahlt werden kann. Eine derartige Ausführung kann als so genannter "Bottom-Emitter" bezeichnet werden.

Alternativ oder zusätzlich kann auch die vom Substrat aus gesehene obere, zweite Elektrode 15 transparent sein sowie die darüber gegebenenfalls angeordnete Verkapselungsanordnung 2 oder Abdeckung. Derartige Vorrichtungen können die im aktiven Bereich erzeugte elektromagnetische Strahlung in eine vom Substrat weggerichtete Richtung und vom Substrat aus gesehen nach oben abstrahlen und können als so genannte "Top-Emitter" bezeichnet werden. Eine gleichzeitig als Bottom- und Top-Emitter ausgeführte Vorrichtung kann im Betrieb beidseitig elektromagnetische Strahlung abstrahlen und im ausgeschalteten Zustand transparent sein.

Im Falle eines als Top-Emitter ausgeführten Bauelements kann auf der zweiten Elektrode 15 zusätzlich eine Lichtauskoppelschicht (nicht gezeigt) aufgebracht sein, die beispielsweise ein Selenid oder ein Sulfid, etwa Zinkselenid oder Zinksulfid, aufweist.

Wird die im aktiven Bereich erzeugte elektromagnetische Strahlung durch eine Verkapselungsanordnung 2 abgestrahlt, so kann insbesondere die zweite Schicht 22 eine Oberflächenstruktur in Form einer Strahlungsauskoppelstruktur mit Aufrauungen, Mikrolinsen und/oder Prismen aufweisen. Durch die konforme, der Oberflächenstruktur der ersten Schicht 21 folgenden zweiten Schicht 22 kann eine derartige Verkapselungsanordnung 2 somit in Kombination eine hermetische Abdichtung und Verkapselung des Bauelements 1 sowie optische Funktionalitäten ermöglichen.

In Figur 8 ist ein Ausführungsbeispiel einer Vorrichtung 800 gezeigt, in der die Verkapselungsanordnung 2 mit der ersten und zweiten Schicht 21, 22 auf den funktionellen Schichten 13, 14 und 15 angeordnet ist. Das Substrat 10, auf dem die funktionellen Schichten 13, 14 und 15 aufgebracht sind, ist im gezeigten Ausführungsbeispiel aus Glas. Das Substrat 10 weist dabei im gezeigten Ausführungsbeispiel eine Dicke von etwa 700 Mikrometern auf, die als erste Elektrode aus ITO ausgebildete funktionelle Schicht 13 eine Dicke von etwa 118 Mikrometern, die als organische funktionelle Schichten ausgebildete Schicht 14 eine Dicke von etwa 120 Nanometern und die als zweite Elektrode aus Aluminium ausgebildete funktionelle Schicht 15 eine Dicke von etwa 200 Nanometern. Die Dicke der ersten Schicht 21 der Verkapselungsanordnung 2 beträgt 500 Nanometer und umfasst einen Schichtenstapel mit einer SiNₓ-Schicht mit einer Dicke von 200 Nanometern, darüber eine SiO₂-Schicht mit einer Dicke von 100 Nanometern und darüber eine weitere SiNₓ-Schicht mit einer Dicke von 200 Nanometern. die zweite Schicht 22 der Verkapselungsanordnung 2 ist aus Al₂O₃ mit einer Dicke von 10 Nanometern. Wie im allgemeinen Teil beschreiben konnte bei dieser Verkapselungsanordnung 2 in der zweiten Schicht kein kristallines Al₂O₃ nachgewiesen werden, so dass die zweite Schicht gänzlich amorph ist.

Bei einer derartigen Vorrichtung 800 konnte, wie im allgemeinen Teil beschrieben, bei 60°C und 90% relativer Luftfeuchtigkeit und einer aktiven Fläche von einem Quadratzentimeter nach 504 Stunden noch kein neu gebildeter Defekt in Form der oben beschriebenen schwarzen Flecken festgestellt werden.

Dadurch, dass die Verkapselungsanordnung 2 direkt auf dem Bauelement 1 beziehungsweise direkt auf den funktionellen Schichten 13, 14 und 15 angeordnet ist, ohne dass eine zusätzliche organische Planarisierungsschicht verwendet werden muss, kann die Anordnung der Verkapselungsanordnung 2 technisch einfach und unaufwändig erfolgen. Im Falle einer organischen Planarisierungsschicht zwischen dem Bauelement 1 und der Verkapselungsanordnung 2 müsste hingegen technisch aufwändig sichergestellt werden, dass die organische Planarisierungsschicht, die üblicherweise nicht hermetisch dicht gegenüber Feuchtigkeit und Sauerstoff ist, von der Verkapselungsanordnung gänzlich bedeckt und umschlossen ist, da ansonsten durch die Planarisierungsschicht Permeationspfade zu den funktionellen Schicht 13, 14, 15 gebildet werden könnten.

In Figur 9 ist eine Vorrichtung 900 gemäß einem weiteren Ausführungsbeispiel gezeigt, das als Substrat die Vorrichtung 200 mit der Verkapselungsanordnung 2 gemäß Figur 2 aufweist. Die auf der als flexibles und hermetisch dichtes Substrat ausgebildeten Vorrichtung angeordneten funktionellen Schichten 13, 14 und 15 sind mit einer weiteren Verkapselungsanordnung 2' mit einer ersten Schicht 21' und einer zweiten Schicht 22' verkapselt. Die Verkapselungsanordnungen 2 und 2' können dabei gleich oder verschieden ausgeführt sein.

In Figur 10 ist eine Vorrichtung 1000 gemäß einem weiteren Ausführungsbeispiel gezeigt, in der im Gegensatz zu den beiden vorangegangenen Ausführungsbeispielen das Substrat 10, etwa eine Kunststofffolie, zusammen mit den funktionellen Schichten 13, 14 und 15 gemeinsam gänzlich umgeben von der Verkapselungsanordnung 2 verkapselt sind.

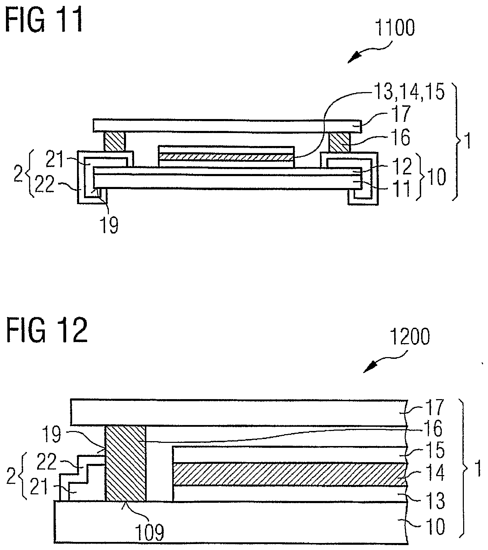

In den Figuren 11 bis 14 sind Vorrichtungen gezeigt, die zusätzlich zur Verkapselung der funktionellen Schichten 13, 14 und 15 eine Abdeckung 17 in Form einer Glasfolie oder Glasplatte oder auch in Form der Vorrichtung 200 aufweisen. Die Abdeckung 17 ist mittels eines um die funktionellen Schichten 13, 14 und 15 umlaufenden Verbindungsmaterials 16 auflaminiert.

Die Vorrichtung 1100 gemäß dem Ausführungsbeispiel der Figur 11 weist ein Bauelement 1 mit einem zweischichtigen Substrat 10 mit einer ersten und einer zweiten Substratschicht 11, 12 auf, die umlaufend im Randbereich mit einer Verkapselungsanordnung 2 verkapselt sind. Dabei ist die erste Substratschicht 11 als Metallfolie und die zweite Substratschicht 12 als polymere Planarisierungsschicht ausgebildet, auf der die funktionellen Schichten 13, 14 und 15 aufgebracht sind.

Die Verkapselungsanordnung 2 erstreckt sich ähnlich wie in Verbindung mit Figur 5 beschrieben über die Verbindungsstelle zwischen der ersten und zweiten Substratschicht 21, 22 und weiterhin über einen Teilbereich der zweiten Substratschicht 22. Das Verbindungsmaterial 16 ist auf der Verkapselungsanordnung 2 aufgebracht, so dass die Verkapselungsanordnung 2 zusammen mit der Abdeckung 17 und der ersten Substratschicht 21 sowohl die zweite Substratschicht 22 als auch die funktionellen Schichten 13, 14 und 15 verkapselt.

Das Verbindungsmaterial 16 ist im gezeigten Ausführungsbeispiel durch Glasfritten gebildet, die hermetisch dicht mit der Abdeckung 17 abschließen können. Dazu kann das Glasfritten-Material auf die durch eine Glasfolie oder eine Glasplatte gebildete Abdeckung 17 vor dem Aufbringen auf das Substrat 10 aufgesintert werden. Nach dem Aufbringen auf die Verkapselungsanordnung 2 auf dem Substrat 10 kann das Verbindungsmaterial 16 beispielsweise mittels eines Lasers aufgeschmolzen werden und dadurch hermetisch dicht an die Verkapselungsanordnung 2 anschließen.

In Figur 12 ist ein Ausschnitt einer Vorrichtung 1200 gemäß einem weiteren Ausführungsbeispiel gezeigt, die als Substrat 10 des Bauelements 1 ein Glassubstrat aufweist. Die Verkapselungsanordnung 2 ist umlaufend um das Verbindungsmaterial 16 auf einem Teilbereich des Verbindungsmaterials 16 und dem Substrat 10 angeordnet, so dass die Grenzfläche 109 zwischen dem Verbindungsmaterial 16 und dem Substrat 10 durch die Verkapselungsanordnung 2 abgedichtet wird. Dadurch können mögliche Permeationspfade für Feuchtigkeit und/oder Sauerstoff durch die Grenzfläche 109, die sich beispielsweise durch mechanische Beanspruchung des Bauelements 1 bilden können, dauerhaft abgedichtet werden.

Das Verbindungsmaterial 16 im gezeigten Ausführungsbeispiel ist ebenfalls aus Glasfritten, das auf die Abdeckung 17 aufgesintert und auf das Substrat 10, etwa ein Glassubstrat, mittels eines Lasers aufgeschmolzen ist. Mögliche Permeationspfade, die entlang der Grenzfläche zwischen dem Substrat 10 und dem Verbindungsmaterial durch den Aufschmelzprozess entstehen können, könne durch die Verkapselungsanordnung 2 effektiv abgedichtet werden.

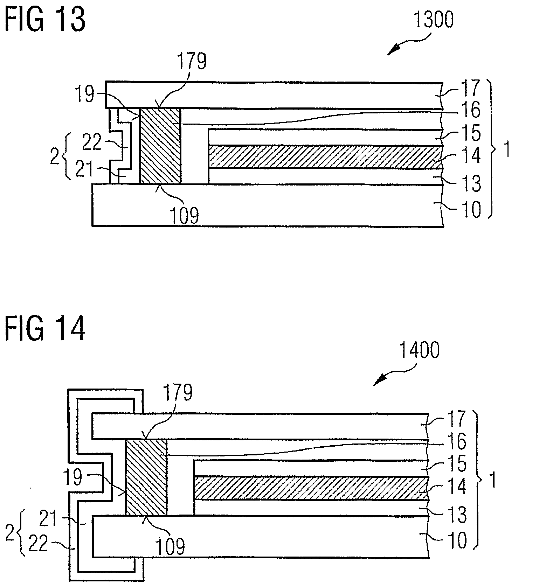

In den Figuren 13 und 14 sind Ausschnitte von Vorrichtungen 1300 und 1400 gemäß weiteren Ausführungsbeispielen gezeigt, bei denen sich die Verkapselungsanordnung 2 zusätzlich noch über das gesamte Verbindungsmaterial 16 und die Grenzfläche 179 zwischen dem Verbindungsmaterial 16 und der Abdeckung 17 erstreckt. Dadurch können das Verbindungsmaterial 16 und auch die Grenzfläche 179 dauerhaft durch die Verkapselungsanordnung 2 abgedichtet werden. Dadurch kann beispielsweise ein Klebstoff als Verbindungsmaterial 16 verwendet werden, der selbst nicht hermetisch dicht ist.

Die Verkapselungsanordnung 2 der Vorrichtung 1400 erstreckt sich zusätzlich noch um das Substrat 10 und die Abdeckung 17 herum, wodurch eine höhere Stabilität erreicht werden kann.

Weiterhin können die Verkapselungsanordnungen der vorab gezeigten Ausführungsbeispiele auf der zweiten Schicht eine Schutzschicht (nicht gezeigt) beispielsweise in Form eines Sprühlacks zum Schutz vor mechanischer Beschädigung aufweisen.

Die Erfindung ist nicht durch die Beschreibung anhand der Ausführungsbeispiele auf diese beschränkt.

## Patentansprüche

1. Vorrichtung, umfassend
- ein Bauelement (1) und
- eine Verkapselungsanordnung (2) zur Verkapselung des Bauelements (1) gegenüber Feuchtigkeit und/oder Sauerstoff,
wobei
- die Verkapselungsanordnung (2) eine erste Schicht (21) und darüber eine zweite Schicht (22) auf zumindest einer Oberfläche (19) des Bauelements (1) aufweist,
- die erste Schicht (21) und die zweite Schicht (22) jeweils ein anorganisches Material aufweisen,
- die erste Schicht (21) direkt auf dem Bauelement (1) angeordnet ist und
- die zweite Schicht (22) direkt auf der ersten Schicht (21) angeordnet ist,
- über der zweiten Schicht (22) eine Schutzschicht aufgebracht ist, die einen Kunststoff aufweist, und/oder das Bauelement (1) eine Abdeckung (17) in Form einer Glasfolie oder einer Glasplatte auf einem Substrat (10) aufweist und die Verkapselungsanordnung (2) zwischen der Abdeckung (17) und dem Substrat (10) angeordnet ist,
- die erste Schicht (21) und die zweite Schicht (22) jeweils eine Volumenstruktur aufweisen,
- die Volumenstruktur der zweiten Schicht (22) unabhängig von der Volumenstruktur der ersten Schicht (21) ist
- die zweite Schicht (22) amorph ist, und **dadurch gekennzeichnet, dass**
- die erste Schicht (21) eine kristalline und/oder polykristalline Volumenstruktur aufweist und eine Schichtenfolge aus zumindest zwei Schichten mit unterschiedlichen Materialien aufweist, wobei die zumindest zwei Schichten mit unterschiedlichen Materialien eine Schicht mit einem Oxid und eine Schicht mit einem Nitrid umfassen.

2. Vorrichtung, umfassend
- ein Bauelement (1) und
- eine Verkapselungsanordnung (2) zur Verkapselung des Bauelements (1) gegenüber Feuchtigkeit und/oder Sauerstoff,
wobei
- die Verkapselungsanordnung (2) eine erste Schicht (21) und darüber eine zweite Schicht (22) auf einer dritten Schicht (23) auf zumindest einer Oberfläche (19) des Bauelements (1) aufweist,
- die dritte Schicht (23) direkt auf dem Bauelement (1) angeordnet ist,
- die erste Schicht (21) direkt auf der dritten Schicht (23) angeordnet ist,
- die zweite Schicht (22) direkt auf der ersten Schicht (21) angeordnet ist,
- die erste Schicht (21) und die zweite Schicht (22) jeweils ein anorganisches Material aufweisen und
- die dritte Schicht (23) ein amorphes anorganisches Material aufweist,
- über der zweiten Schicht (22) eine Schutzschicht aufgebracht ist, die einen Kunststoff aufweist, und/oder das Bauelement (1) eine Abdeckung (17) in Form einer Glasfolie oder einer Glasplatte auf einem Substrat (10) aufweist und die Verkapselungsanordnung (2) zwischen der Abdeckung (17) und dem Substrat (10) angeordnet ist,
- die erste Schicht (21) und die zweite Schicht (22) jeweils eine Volumenstruktur aufweisen,
- die Volumenstruktur der zweiten Schicht (22) unabhängig von der Volumenstruktur der ersten Schicht (21) ist
- die zweite Schicht (22) amorph ist, und **dadurch gekennzeichnet, dass**
- die erste Schicht (21) eine kristalline und/oder polykristalline Volumenstruktur aufweist und eine Schichtenfolge aus zumindest zwei Schichten mit unterschiedlichen Materialien aufweist, wobei die zumindest zwei Schichten mit unterschiedlichen Materialien eine Schicht mit einem Oxid und eine Schicht mit einem Nitrid umfassen.

3. Vorrichtung nach dem vorherigen Anspruch, wobei
- die zweite Schicht (22) und die dritte Schicht (23) gleich ausgebildet sind.

4. Vorrichtung, umfassend
- ein Bauelement (1) und
- eine Verkapselungsanordnung (2) zur Verkapselung des Bauelements (1) gegenüber Feuchtigkeit und/oder Sauerstoff,
wobei
- die Verkapselungsanordnung (2) eine erste Schicht (21) und darüber eine zweite Schicht (22) auf zumindest einer Oberfläche (19) des Bauelements (1) aufweist,
- die erste Schicht (21) und die zweite Schicht (22) jeweils ein anorganisches Material aufweisen,
- die zweite Schicht (22) direkt auf der ersten Schicht (21) angeordnet ist und
- die Verkapselungsanordnung (2) bei einer Temperatur von größer oder gleich 60°C und bei einer relativen Luftfeuchtigkeit von größer oder gleich 85% länger als 500 Stunden hermetisch dicht ist,
- über der zweiten Schicht (22) eine Schutzschicht aufgebracht ist, die einen Kunststoff aufweist, und/oder das Bauelement (1) eine Abdeckung (17) in Form einer Glasfolie oder einer Glasplatte auf einem Substrat (10) aufweist und die Verkapselungsanordnung (2) zwischen der Abdeckung (17) und dem Substrat (10) angeordnet ist,
- die erste Schicht (21) und die zweite Schicht (22) jeweils eine Volumenstruktur aufweisen,
- die Volumenstruktur der zweiten Schicht (22) unabhängig von der Volumenstruktur der ersten Schicht (21) ist
- die zweite Schicht (22) amorph ist, und **dadurch gekennzeichnet, dass**
- die erste Schicht eine kristalline und/oder polykristalline Volumenstruktur aufweist und eine Schichtenfolge aus zumindest zwei Schichten mit unterschiedlichen Materialien aufweist, wobei die zumindest zwei Schichten mit unterschiedlichen Materialien eine Schicht mit einem Oxid und eine Schicht mit einem Nitrid umfassen.

5. Vorrichtung nach einem der vorherigen Ansprüche, wobei
- die zweite Schicht (22) eine Dicke (9) mit einer Dickenvariation aufweist, die unabhängig von einer Oberflächenstruktur und/oder einer Volumenstruktur der ersten Schicht (21) ist.

6. Vorrichtung nach Anspruch 5, wobei
- die Dickenvariation kleiner oder gleich 10% ist.

7. Vorrichtung nach einem der vorherigen Ansprüche, wobei
- die Verkapselungsanordnung (2) eine Mehrzahl von ersten Schichten (21, 21') und eine Mehrzahl von zweiten Schichten (22, 22') aufweist und
- die ersten und zweiten Schichten (21, 21', 22, 22') abwechselnd übereinander aufgebracht sind.

8. Vorrichtung nach einem der vorherigen Ansprüche, wobei
- die Verkapselungsanordnung (2) das Bauelement (1) gänzlich umschließt.

9. Vorrichtung nach einem der vorherigen Ansprüche, wobei
- die Vorrichtung eine Mehrzahl von Verkapselungsanordnungen (2, 2') aufweist, die auf verschiedenen Oberflächen des Bauelements (1) angeordnet sind.

10. Vorrichtung nach einem der vorherigen Ansprüche, wobei
- das Bauelement (1) ein Substrat (10) umfasst und
- die Verkapselungsanordnung (2) direkt auf dem Substrat (10) aufgebracht ist.

11. Vorrichtung nach einem der Ansprüche 1 bis 9, wobei
- das Bauelement (1) eine Abdeckung (17) auf einem Substrat (10) aufweist und
- die Verkapselungsanordnung (2) zwischen der Abdeckung (17) und dem Substrat (10) angeordnet ist.

12. Vorrichtung nach dem vorherigen Anspruch, wobei
- zwischen der Abdeckung (17) und dem Substrat (10) ein Verbindungsmaterial (16) angeordnet ist und
- die Verkapselungsanordnung (2) eine Grenzfläche (109, 179) zwischen dem Substrat (10) und dem Verbindungsmaterial (16) und/oder zwischen der Abdeckung (17) und dem Verbindungsmaterial (16) verkapselt.

## Claims

1. A device comprising
- a component (1) and
- an encapsulation arrangement (2) for the encapsulation of the component (1) with respect to moisture and/or oxygen,
wherein
- the encapsulation arrangement (2) has a first layer (21) and thereabove a second layer (22) on at least one surface (19) of the component (1),
- the first layer (21) and the second layer (22) each comprise an inorganic material,
- the first layer (21) is arranged directly on the component (1), and
- the second layer (22) is arranged directly on the first layer (21),
- a protective layer comprising plastics is arranged on the second layer (22) and/or the component (1) has a covering (17) in the form of a glass film or glass plate on a substrate (10) and the encapsulation arrangement (2) is arranged between the covering (17) and the substrate (10),
- the first layer (21) and the second layer (22) each have a volume structure, and
- the volume structure of the second layer (22) is independent of the volume structure of the first layer (21),
- the second layer is amorphous, and
**characterized in that**
- the first layer (21) has a crystalline and/or polycrystalline volume structure and comprises a layer sequence composed of at least two layers comprising different materials, wherein the at least two layers comprising different materials comprise a layer comprising an oxide and a layer comprising a nitride.

2. A device comprising
- a component (1) and
- an encapsulation arrangement (2) for the encapsulation of the component (1) with respect to moisture and/or oxygen,
wherein
- the encapsulation arrangement (2) has a first layer (21) and thereabove a second layer (22) on a third layer (23) on at least one surface (19) of the component (1),
- the third layer (23) is arranged directly on the component (1),
- the first layer (21) is arranged directly on the third layer (23),
- the second layer (22) is arranged directly on the first layer (21),
- the first layer (21) and the second layer (22) each comprise an inorganic material, and
- the third layer (23) comprises an amorphous inorganic material,
- a protective layer comprising plastics is arranged on the second layer (22) and/or the component (1) has a covering (17) in the form of a glass film or glass plate on a substrate (10) and the encapsulation arrangement (2) is arranged between the covering (17) and the substrate (10),
- the first layer (21) and the second layer (22) each have a volume structure, and
- the volume structure of the second layer (22) is independent of the volume structure of the first layer (21),
- the second layer is amorphous, and
**characterized in that**
- the first layer (21) has a crystalline and/or polycrystalline volume structure and comprises a layer sequence composed of at least two layers comprising different materials, wherein the at least two layers comprising different materials comprise a layer comprising an oxide and a layer comprising a nitride.

3. The device as claimed in the preceding claim, wherein
- the second layer (22) and the third layer (23) are embodied identically.

4. A device comprising
- a component (1) and
- an encapsulation arrangement (2) for the encapsulation of the component (1) with respect to moisture and/or oxygen,
wherein
- the encapsulation arrangement (2) has a first layer (21) and thereabove a second layer (22) on at least one surface (19) of the component (1),
- the first layer (21) and the second layer (22) each comprise an inorganic material,
- the second layer (22) is arranged directly on the first layer (21), and
- the encapsulation arrangement (2) is hermetically impermeable at a temperature of greater than or equal to 60°C and at a relative air humidity of greater than or equal to 85% for longer than 500 hours,
- a protective layer comprising plastics is arranged on the second layer (22) and/or the component (1) has a covering (17) in the form of a glass film or glass plate on a substrate (10) and the encapsulation arrangement (2) is arranged between the covering (17) and the substrate (10),
- the first layer (21) and the second layer (22) each have a volume structure, and
- the volume structure of the second layer (22) is independent of the volume structure of the first layer (21),
- the second layer is amorphous, and
**characterized in that**
- the first layer (21) has a crystalline and/or polycrystalline volume structure and comprises a layer sequence composed of at least two layers comprising different materials, wherein the at least two layers comprising different materials comprise a layer comprising an oxide and a layer comprising a nitride.

5. The device as claimed in any of the preceding claims, wherein
- the second layer (22) has a thickness (9) having a thickness variation which is independent of a surface structure and/or a volume structure of the first layer (21) .

6. The device as claimed in claim 5, wherein
- the thickness variation is less than or equal to 10%.

7. The device as claimed in any of the preceding claims, wherein
- the encapsulation arrangement (2) has a plurality of first layers (21, 21') and a plurality of second layers (22, 22'), and
- the first and second layers (21, 21', 22, 22') are applied alternately one above another.

8. The device as claimed in any of the preceding claims, wherein
- the encapsulation arrangement (2) completely encloses the component (1).

9. The device as claimed in any of the preceding claims, wherein
- the device has a plurality of encapsulation arrangements (2, 2') arranged on different surfaces of the component (1).

10. The device as claimed in any of the preceding claims, wherein
- the component (1) comprises a substrate (10), and
- the encapsulation arrangement (2) is applied directly on the substrate (10).

11. The device as claimed in any of claims 1 to 9, wherein
- the component (1) has a covering (17) on a substrate (10), and
- the encapsulation arrangement (2) is arranged between the covering (17) and the substrate (10).

12. The device as claimed in the preceding claim, wherein
- a connecting material (16) is arranged between the covering (17) and the substrate (10), and
- the encapsulation arrangement (2) encapsulates an interface (109, 179) between the substrate (10) and the connecting material (16) and/or between the covering (17) and the connecting material (16).

## Revendications

1. Un dispositif comprenant
- un composant (1) et
- un arrangement d'encapsulation (2) pour l'encapsulation du composant (1) contre l'humidité et/ou l'oxygène,
dans lequel
- l'arrangement d'encapsulation (2) comprend une première couche (21) et, au-dessus de celle-ci, une deuxième couche (22) sur au moins une surface (19) du composant (1),
- la première couche (21) et la deuxième couche (22) comprennent chacune un matériau inorganique,
- la première couche (21) est arrangée directement sur le composant (1), et
- la deuxième couche (22) est arrangée directement sur la première couche (21),
- une couche protectrice comprenant du plastique est disposée sur la deuxième couche (22) et/ou le composant (1) comprend un revêtement (17) sous la forme d'un film de verre ou d'une plaque de verre sur un substrat (10) et l'arrangement d'encapsulation (2) est disposé entre le revêtement (17) et le substrat (10),
- la première couche (21) et la deuxième couche (22) ont chacune une structure volumique, et
- la structure volumique de la deuxième couche (22) est indépendante de la structure volumique de la première couche (21),
- la deuxième couche est amorphe, et
**caractérisé en ce que**
- la première couche (21) comprend une structure volumique cristalline et/ou polycristalline et comprend une séquence de couches composée d'au moins deux couches comprenant des matériaux différents, dans laquelle les au moins deux couches comprenant des matériaux différents comprennent une couche comprenant un oxyde et une couche comprenant un nitrure.

2. Un dispositif comprenant
- un composant (1) et
- un arrangement d'encapsulation (2) pour l'encapsulation du composant (1) contre l'humidité et/ou l'oxygène,
dans lequel
- l'arrangement d'encapsulation (2) comprend une première couche (21) et, au-dessus de celle-ci, une deuxième couche (22) sur une troisième couche (23) sur au moins une surface (19) du composant (1),
- la troisième couche (23) est arrangée directement sur le composant (1),
- la première couche (21) est arrangée directement sur la troisième couche (23),
- la deuxième couche (22) est directement arrangée sur la première couche (21),
- la première couche (21) et la deuxième couche (22) comprennent chacune un matériau inorganique, et
- la troisième couche (23) comprend un matériau inorganique amorphe,
- une couche protectrice comprenant du plastique est disposée sur la deuxième couche (22) et/ou le composant (1) comprend un revêtement (17) sous la forme d'un film de verre ou d'une plaque de verre sur un substrat (10) et l'arrangement d'encapsulation (2) est disposé entre le revêtement (17) et le substrat (10),
- la première couche (21) et la deuxième couche (22) ont chacune une structure volumique, et
- la structure volumique de la deuxième couche (22) est indépendante de la structure volumique de la première couche (21),
- la deuxième couche est amorphe, et
**caractérisé en ce que**
- la première couche (21) comprend une structure volumique cristalline et/ou polycristalline et comprend une séquence de couches composée d'au moins deux couches comprenant des matériaux différents, dans laquelle les au moins deux couches comprenant des matériaux différents comprennent une couche comprenant un oxyde et une couche comprenant un nitrure.

3. Le dispositif selon la revendication précédente, dans lequel
- la deuxième couche (22) et la troisième couche (23) sont formées de la manière égal.

4. Un dispositif comprenant
- un composant (1) et
- un arrangement d'encapsulation (2) pour l'encapsulation du composant (1) contre l'humidité et/ou l'oxygène,
dans lequel
- l'arrangement d'encapsulation (2) comprend une première couche (21) et, au-dessus de celle-ci, une deuxième couche (22) sur au moins une surface (19) du composant (1),
- la première couche (21) et la deuxième couche (22) comprennent chacune un matériau inorganique,
- la deuxième couche (22) est arrangée directement sur la première couche (21), et
- l'arrangement d'encapsulation (2) est hermétiquement imperméable à une température supérieure ou égale à 60°C et à une humidité relative de l'air supérieure ou égale à 85% pendant plus de 500 heures,
- une couche protectrice comprenant du plastique est disposée sur la deuxième couche (22) et/ou le composant (1) comprend un revêtement (17) sous la forme d'un film de verre ou d'une plaque de verre sur un substrat (10) et l'arrangement d'encapsulation (2) est disposé entre le revêtement (17) et le substrat (10),
- la première couche (21) et la deuxième couche (22) ont chacune une structure volumique, et
- la structure volumique de la deuxième couche (22) est indépendante de la structure volumique de la première couche (21),
- la deuxième couche est amorphe, et
**caractérisé en ce que**
- la première couche (21) comprend une structure volumique cristalline et/ou polycristalline et comprend une séquence de couches composée d'au moins deux couches comprenant des matériaux différents, dans laquelle les au moins deux couches comprenant des matériaux différents comprennent une couche comprenant un oxyde et une couche comprenant un nitrure.

5. Le dispositif selon l'une des revendications précédentes, dans lequel
- la deuxième couche (22) a une épaisseur (9) avec une variation d'épaisseur qui est indépendante d'une structure de surface et/ou d'une structure volumique de la première couche (21).

6. Le dispositif selon la revendication 5, dans lequel
- la variation d'épaisseur est inférieure ou égale à 10 %.

7. Le dispositif selon l'une des revendications précédentes, dans lequel
- l'arrangement d'encapsulation (2) comprend une pluralité de premières couches (21, 21') et une pluralité de deuxième couches (22, 22'), et
- la première et la deuxième couche (21, 21', 22, 22') sont appliquées alternativement l'une au-dessus de l'autre.

8. Le dispositif selon l'une des revendications précédentes, dans lequel
- l'arrangement d'encapsulation (2) entoure complètement le composant (1).

9. Le dispositif selon l'une des revendications précédentes, dans lequel
- le dispositif comprend une pluralité d'arrangements d'encapsulation (2, 2') disposés sur différentes surfaces du composant (1).

10. Le dispositif selon l'une des revendications précédentes, dans lequel
- le composant (1) comprend un substrat (10), et
- l'arrangement d'encapsulation (2) est appliqué directement sur le substrat (10).

11. Le dispositif selon l'une des revendications 1 à 9, dans lequel
- le composant (1) a un revêtement (17) sur un substrat (10), et
- l'arrangement d'encapsulation (2) est disposé entre le revêtement (17) et le substrat (10).

12. Le dispositif selon la revendication précédente, dans lequel
- un matériau de connexion (16) est disposé entre le revêtement (17) et le substrat (10), et
- l'arrangement d'encapsulation (2) encapsule une interface (109, 179) entre le substrat (10) et le matériau de connexion (16) et/ou entre le revêtement (17) et le matériau de connexion (16).
